Europäisches Patentamt

European Patent Office

Office européen des brevets

(19)

(11) Veröffentlichungsnummer: **0 264 999**
**A2**

(12) **EUROPÄISCHE PATENTANMELDUNG**

(21) Anmeldenummer: **87201914.6**

(22) Anmeldetag: **07.10.87**

(51) Int. Cl.⁴ **H03M 3/04**

(30) Priorität: **11.10.86 DE 3634691**

(43) Veröffentlichungstag der Anmeldung:
**27.04.88 Patentblatt 88/17**

(84) Benannte Vertragsstaaten:
**DE FR GB IT**

(71) Anmelder: **Philips Patentverwaltung GmbH**
**Wendenstrasse 35 Postfach 10 51 49**
**D-2000 Hamburg 1(DE)**

(84) **DE**

(71) Anmelder: **N.V. Philips' Gloeilampenfabrieken**
**Groenewoudseweg 1**
**NL-5621 BA Eindhoven(NL)**

(84) **FR GB IT**

(72) Erfinder: **Rosebrock, Jens**
**Billungstrasse 30 A**
**D-2820 Bremen 70(DE)**

(74) Vertreter: **Poddig, Dieter, Dipl.-Ing. et al**
**Philips Patentverwaltung GmbH**
**Wendenstrasse 35 Postfach 10 51 49**
**D-2000 Hamburg 1(DE)**

(54) **System zum Übertragen oder Speichern von Eingangssignalen.**

(57) Bei bekannten Systemen müssen im Differenzpulscodemodulator an einer Stelle in einer zeitkritischen Schleife eine Anzahl Verarbeitungsschritte innerhalb eines Abtasttaktes durchgeführt werden, nämlich eine Summenbildung, eine Multiplikation mit Addition, eine Differenzbildung und eine Quantisierung. Für den insbesondere bei der Bildverarbeitung fast immer auftretenden Fall, daß zwischen den für den Vorhersagewert verwendeten Signalen eine Anzahl Signale liegt, die nicht für den Vorhersagewert verwendet werden, wird eine Lösung angegeben, bei der innerhalb der zeitkritischen Schleife nur eine Zuordnung und eine Addition erforderlich ist. Eine solche Anordnung entspricht einer speziellen Aufteilung der Gleichung für das Vorhersage-fehlersignal in einzelne Terme. Die angegebene Lösung läßt sich in verschiedener Weise zur Einsparung von Aufwand abwandeln und auch für adaptive Modulatoren verwenden. Die gleichen Maßnahmen können auch im Demodulator verwendet werden.

Fig. 2

EP 0 264 999 A2

## System zum übertragen oder Speichern von Eingangssignalen

Die Erfindung betrifft ein System zum übertragen oder Speichern von Eingangssignalen mit einem eingangsseitigen Differenzpulscodemodulator, der die einem Systemeingang zugeführten Eingangssignale in Form einer Folge von mit einem Taktsignal nacheinander auftretenden Signalwerten empfängt und mit jedem Taktsignal einen quantisierten Vorhersagefehlersignalwert an einem Modulatorausgang abgibt, und mit einem ausgangsseitigen Differenzpulscodedemodulator, der an einem Demodulatoreingang die quantisierten Vorhersagefehlersignalwerte in Form einer mit einem Taktsignal auftretenden Folge empfängt und zu jedem Vorhersagefehlersignalwert einen rekonstruierten Signalwert erzeugt und einem Systemausgang zuführt.

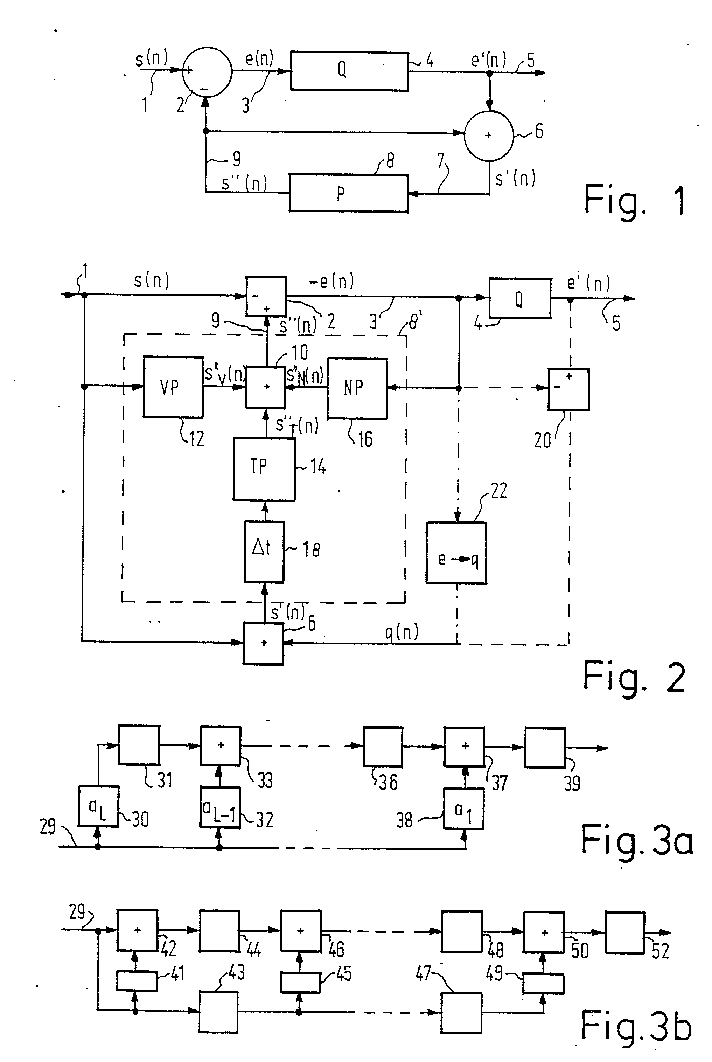

Derartige Systeme sind allgemein bekannt und dienen dazu, die Eingangssignale mit möglichst wenig Informationen darzustellen, ohne die rekonstruierten Signale zu sehr zu verfälschen. Ein Differenzpulscodemodulator für ein derartiges System ist beispielsweise bekannt aus der Zeitschrift "IEEE Transactions on Communications", Vol. Com-30, No. 5, May 1982, Seiten 1174-1184, und weist die in Fig. 1 dargestellte Prinzipielle Struktur auf. Die Eingangssignalwerte s(n) werden dem Eingang 1 aufeinanderfolgend mit einem Takt mit der Periode t zugeführt, wobei n einen beliebigen Zeitpunkt innerhalb der Folge bezeichnet. In der Differenzstufe 2 wird von jedem Eingangssignalwert s(n) ein intern erzeugter Vorhersagesignalwert s″(n) subtrahiert, der über die Leitung 9 zugeführt wird, und am Ausgang 3 der Differenzstufe 2 entsteht der Vorhersagefehlersignalwert e(n). Dieser wird einem Quantisierer 4 zugeführt, der bestimmten Wertebereichen des Vorhersagefehlersignals e bestimmte Werte des quantisierten Vorhersagefehlersignals e′ zuordnet und diese oder die kodierte wertebereichnummer am Ausgang 5 abgibt. Der quantisierte Vorhersagefehlersignalwert e′ wird dem ersten Eingang eines ersten Addierers 6 zugeführt, dessen zweiter Eingang über die Leitung 9 den Vorhersagesignalwert s″(n) erhält und der auf seiner Ausgangsleitung 7 den rekonstruierten Signalwert s′(n) abgibt und einem Prädiktor 8 zuführt. Dieser Prädiktor 8 erzeugt aufeinanderfolgend die Summe jeweils einer Anzahl vorhergehender, unterschiedlich gewichteter rekonstruierter Signalwerte s′(n-m), und zwar mit Hilfe von Multiplizierern und Verzögerungseinrichtungen, und jede so gebildete Summe stellt einen Vorhersagesignalwert s″(n) dar, der auf der Leitung 9 abgegeben wird. Je nach dem Ausmaß der Korrelation der Eingangssignalwerte s(n) untereinander ist der Wertebereich des Vorhersagefehlersignals e im Mittel erheblich verringert, und durch die Quantisierung wird noch eine weitere Reduktion der Informationsmenge erreicht, so daß bei binärer Darstellung aller Signale das quantisierte Vorhersagefehlersignal e′ auf der Ausgangsleitung 5 erheblich weniger Bit umfaßt als das Eingangssignal s am Eingang 1. Da der Addierer 6 das quantisierte Vorhersagefehlersignal e′ zur Bildung des rekonstruierten Signals s′ verwendet, werden die Quantisierungsfehler ständig berücksichtigt, so daß sich im quantisierten Vorhersagefehlersignal e′ keine Quantisierungsfehler aufsummieren können.

Wie aus Fig. 1 zu erkennen ist, muß in einer zeitkritischen Schleife innerhalb der Periode eines Taktsignals die Differenzbildung in der Differenzstufe 2, die Bildung des quantisierten Vorhersagefehlers e′ im Quantisierer 4, die Addition im Addierer 6 und vor allem die Bildung der gewichteten Summe im Prädiktor 8 durchgeführt werden, damit nach dem Anlegen eines Eingangssignalwerts s(n) bis zum Eintreffen des folgenden Eingangssignalwerts s(n+1) der zugehörige Vorhersagesignalwert s″(n+1) zur Verfügung steht. Die genannten Elemente bilden somit die zeitkritische Schleife. Bei hohen Frequenzen des Taktsignals, d.h. hohen Folgefrequenzen der Eingangssignalwerte, wie beispielsweise bei Fernsehbildsignalen, steht für diese Folge von Verarbeitungsschritten innerhalb der zeitkritischen Schleife nur eine sehr kurze Zeit zur Verfügung, so daß für die Durchführung der einzelnen Signalverarbeitungen sehr schnelle Bauelemente verwendet werden müssen, die teuer sind und viel Energie benötigen.

In der oben genannten Druckschrift ist in Fig. 3 eine Umformung des Differenzpulscodemodulator vorgenommen worden, die zwei Prädiktoren verwendet. Diese Umformung dient jedoch nur zur Untersuchung der Stabilität einer derartigen Anordnung und verringert im übrigen nicht die Anzahl der innerhalb einer Taktperiode erforderlichen Verarbeitungsschritte.

In der DE-OS 34 17 139 ist ein Differenzpulscodemodulator für hohe Verarbeitungsgeschwindigkeiten beschrieben, bei dem in der zeitkritischen Schleife ein Addierer weniger verwendet werden soll als beim Stand der Technik. Dieser Addierer soll jedoch lediglich bei der Summenbildung des Vorhersagesignals in parallelen prädiktoren eingesPart werden, so daß die zeitkritische Schleife weiterhin noch die vier Elemente Differenzstufe, Quantisierer, Addierer und Prädiktor enthält.

Ferner ist aus der EP-Patentanmeldung 176 821 ein Differenzpulscodemodulator bekannt, bei dem ebenfalls die Anzahl der Bearbeitungsschritte in der zeitkritischen Schleife verringert werden soll. Dafür ist die Differenzstufe in zwei einzelne Differenzstufen aufgeteilt, die durch ein Register getrennt sind. Die dem Quantisierer unmittelbar vorgeschaltete Differenzstufe erhält am subtrahierenden Eingang das mit einem Koeffizienten multiplizierte quantisierte Vorhersagefehlersignal anstelle des rekonstruierten Signals, so daß die zeitkritische Schleife einen Addierer weniger enthält. Dabei ist aber offensichtlich davon ausgegangen, daß jeder Vorhersagesignalwert nur aus dem letzten vorhergegangenen Vorhersagefehlersignalwert gebildet wird, und zwar mittels eines Koeffizienten, der sich als ganze negative Potenz von zwei darstellen läßt. Die Erweiterung dieser Anordnung auf andere Fälle, insbesondere auf Bildung jedes Vorhersagewertes aus mehreren vergangenen Vorhersagefehlersignalwerten bzw. rekonstruierten Signalwerten, ist daraus nicht ohne weiteres zu entnehmen.

Aufgabe der vorliegenden Erfindung ist es, ein System der eingangs genannten Art anzugeben, bei dem sowohl im Modulator als auch im Demodulator innerhalb einer Taktzeit der Eingangssignalwerte eine verringerte Anzahl von Verarbeitungsschritten erforderlich ist, die mit einfachen Bauelementen durchgeführt werden können, wobei auch eine einfache Verwendung als Demodulator möglich ist.

Diese Aufgabe wird erfindungsgemäß dadurch gelöst, daß der Modulator eine Differenzstufe, die an einem ersten Eingang mit jedem Taktsignal einen Eingangssignalwert empfängt, einen Quantisierer, der mit jedem Taktsignal einen internen erzeugten Vorhersagefehlersignalwert empfängt und den quantisierten Vorhersagefehlersignalwert abgibt, einen Vorprädiktor, einen Teilprädiktor und einen Nachprädiktor, die mit der Differenzstufe und dem Quantisierer gekoppelt sind und von denen mit jedem Taktsignal der Vorprädiktor einen ersten Vorhersageteilsignalwert aus der Multiplikation einer ersten Anzahl gehörenden Eingangssignalwerte direkt mit einer zugehörigen ersten Anzahl Koeffizienten und der Teilprädiktor einen zweiten Vorhersageteilsignalwert aus der Multiplikation einer zweiten Anzahl rekonstruierter Signalwerte mit einer zugehörigen zweiten Anzahl Koeffizienten erzeugt, wobei die zweite Anzahl rekonstruierter Signalwerte zu eine rzweiten Anzahl früherer Eingangssignalwerte gehört, die mit einer zeitlichen Lücke vor der ersten Anzahl liegen, und im Nachprädiktor, der eine in Reihe geschaltete Kette aus einer der ersten Anzahl entsprechenden Anzahl von abwechselnd einem weiteren Addierer und einer Verzögerungsstufe mit einer Verzögerungszeit von je einer Taktzeit enthält,

-der erste der weiteren Addierer an einem Eingang die Differenz aus einem Eingangssignalwert und der Summe der beiden Vorhersageteilsignalwerte, von denen mindestens der zweite Vorhersageteilsignalwert durch eine erste Verzögerungsanordnung zeitrichtig verschoben ist, erhält und

-alle weiteren Addierer der Kette an ihren nicht mit einer Verzögerungsstufe verbundenen Eingängen das Ausgangssignal jeweils eines vom Vorhersagefehlersignalwert direkt angesteuerter Zuordners, erhalten und

-die letzte Verzögerungsstufe der Kette den Vorhersagefehlersignalwert abgibt, und einen ersten Addierer enthält, der mit jedem Taktsignal an einem ersten Eingang den aus dem Vorhersagefehlersignalwert in einer weiteren Stufe gebildeten Quantisierungsfehlersignalwert und an einem zweiten Eingang über eine zweite Verzögerungsanordnung mit einer der ersten Anzahl Taktsignale entsprechenden Verzögerungszeit den Eingangssignalwert, der dem Vorhersagefehlersignalwert zeitlich entspricht, empfängt, und jeweils einen rekonstruierten Signalwert abgibt, und daß der Demodulator wenigstens einen Teilprädiktor mit zugehöriger erster Verzögerungsanordnung und einen Nachprädiktor enthält, die entsprechend dem Modulator aufgebaut sind und von denen der Nachprädiktor wenigstens die Summe eines Ausgangssignalwerts des Teilprädiktors und eines vom quantisierten Vorhersagefehlersignalwerts am Demodulatoreingang abgeleiteten Signalwert und der Teilprädiktor einen vom Ausgang des Nachprädiktors abgeleiteten Signalwert empfangen und die rekonstruierten Signalwerte von den Ausgangssignalwerten des NachPrädiktors ableitbar sind.

Gemäß der erfindungsgemäßen Lösung befindet sich in der zeitkritischen Schleife des Modulators und des Demodulators für jeden Koeffizienten der ersten Anzahl nunmehr nur ein Zuordner und ein Addierer des Nachprädiktors, so daß innerhalb einer Taktperiode nur eine Durchlaufzeit durch den Zuordner und die Addition des von diesem abgegebenen Signalwertes erforderlich ist. Alle anderen Signalverarbeitungsschritte können in Stufen ausgeführt werden, bei denen insbesondere für die Multiplikation mit den Koeffizienten nahezu beliebig viel Zeit zur Verfügung steht. Dies gilt insbesondere für den Vorprädiktor, aber auch für den Teilprädiktor, wenn die zeitliche Lücke groß ist, wie es häufig z.B. bei Speicherung oder Übertragung von Bilddaten der Fall ist. Wenn keine zeitliche Lücke vorhanden ist, kann der Teilprädiktor auch entfallen. Durch die erfindungsgemäße Aufteilung des Prädiktors und die Anordnung der Teile erhält die Differenzstufe nun nicht mehr unmittelbar die vollständigen Vorhersagesignalwerte, sondern nur Vorhersageteilsignalwerte. Der Zuordner kann durch einen parallelen Multiplizierer oder, da die Koeffizienten festliegen, noch einfacher durch einen oder mehrere parallele Festwertspeicher gebildet sein. Da das quantisierte Vorhersagefehlersignal nicht mehr für den Prädiktor benutzt wird, kann der Quantisierer dieses letztere Signal direkt in kodierter Form, z.B. als kodierte Quantisierungsstufennummer, erzeugen.

Die Bildung der Summe der beiden Vorhersageteilsignalwerte und der Differenz zum Eingangssignal kann grundsätzlich in einer entsprechend aufgebauten einzigen Stufe durchgeführt werden. Eine einfachere Lösung ist nach einer Ausgestaltung der Erfindung dadurch gekennzeichnet, daß wenigstens im Modulator für die Bildung der Summe der beiden Vorhersageteilsignalwerte und der Differenz mit dem Eingangssignalwert je ein eigener Addierer bzw. eine eigene Differenzstufe vorgesehen ist, denen jeweils eine Verzögerungsstufe für eine Taktzeitnachgeschaltet ist, die das jeweilige Zwischenergebnis bzw. Endergebnis liefert, und daß die Verzögerung der Signalwerte durch diese Verzögerungsstufen in der Verzögerungszeit der ersten und der zweiten Verzögerungsanordnung berücksichtigt ist. Diese Weiterbildung berücksichtigt die Tatsache, daß vor dem Teilprädiktor und dem Nachprädiktor, bei ausreichend großen Lücken auch im Teilprädiktor selbst eine Erhöhung der Signalbearbeitungszeit ohne Schwierigkeiten möglich ist und sich lediglich in einer erhöhten Durchlaufzeit des Signals durch die gesamte Anordnung äußert, die jedoch fast immer nebensächlich ist, so daß einfache Standardstufen für die Addition bzw. Subtraktion jeweils zweier Signale verwendet werden können, für die je eine ganze Taktzeit zur Verfügung steht.

Die Multiplikationen im Vorprädiktor und im Teilprädiktor können zwar ebenfalls durch Zuordner, z.B. in Form von Festwertspeichern durchgeführt werden, die jedoch insbesondere bei großen Wertebereichen der Signale aufwendig sind. Eine weniger aufwendige Lösung ist daher dadurch gekennzeichnet, daß mindestens der Vorprädiktor eine weitere Kette aus abwechselnd einem weiteren Addierer und einer Verzögerungsstufe enthält, von denen die weiteren Addierer an ihren anderen, nicht für die Reihenschaltung verwendeten Eingängen die dem Vorprädiktor zugeführten Signalwerte über Multiplizierer empfangen, die die Multiplikation eines Koeffizienten mit einem Signalwert durch dessen im Taktsignalabstand aufeinanderfolgende stellenverschobene Addition durchführen, wobei die Gesamtverzögerung in jedem Multiplizierer gleich ist, und daß die Differenzstufe die Eingangssignalwerte über eine dritte Verzögerungsanordnung erhält, deren Verzögerungszeit der Gesamtverzögerung jedes Multiplizierers entspricht. Durch die Verwendung der dritten Verzögerungsanordnung kann die Signalverzögerungszeit im Vorprädiktor relativ groß sein, so daß die Durchführung der Multiplikationen mit den Koeffizienten in Form von aufeinanderfolgenden Additionen mit relativ langsamen Bauelementen erfolgen kann.

Nach einer weiteren Ausgestaltung der Erfindung ist auch der Teilprädiktor entsprechend dem Vorprädiktor aufgebaut und die Verzögerungszeit der mit dem Teilprädiktor in Reihe geschalteten ersten Verzögerungsanordnung um die Gesamtverzögerung der Multiplizierer im Teilprädiktor verkürzt gewählt. Hier wird also die Signallaufzeit durch den Teilprädiktor in der ersten Verzögerungsanordnung berücksichtigt, so daß auch der Teilprädiktor mit relativ langsamen Bauelementen aufgebaut sein kann. Wie später genauer gezeigt wird, muß die Signaldurchlaufzeit durch den Teilprädiktor lediglich kürzer sein als die zeitliche Lücke zwischen den Signalwerten, aus denen jeder der beiden Vorhersageteilsignalwerte gebildet werden, was jedoch in fast allen Anwendungsfällen gegeben ist.

Besonders in dem Fall, wo diese zeitliche Lücke relativ groß ist, können nach einer weiteren Ausgestaltung der Erfindung Verzögerungsstufen insbesondere auch in den Verzögerungsanordnungen gespart werden, indem der erste der im Vorprädiktor enthaltenen weiteren Addierer am einen Eingang die zweiten Vorhersageteilsignalwerte von dem Ausgang des Teilprädiktors empfängt und die Verzögerungszeit der ersten Verzögerungsanordnung zusätzlich um die Anzahl Verzögerungsstufen in der weiteren Kette im Vorprädiktor kürzer gewählt ist. Hier wird die Tatsache ausgenutzt, daß die Reihenfolge der Addition mehrerer Signale grundsätzlich gleichgültig ist.

Die für den ersten Eingang des ersten Addierers benötigten Quantisierungsfehlersignalwerte können auf verschiedene Weise erzeugt werden, beispielsweise ebenfalls durch Ansteuerung eines Zuordners durch die Vorhersagefehlersignalwerte oder durch eine Differenzstufe, der auch noch eine zusätzliche Verzögerungsstufe nachgeschaltet werden kann, um die erforderlichen Signalverarbeitungsgeschwindigkeiten zu verringern, wobei die Verzögerungszeit dieser zusätzlichen Verzögerungsstufe in anderen Stufen berücksichtigt werden kann. Eine besonders einfache Ausführung, bei der die Bildung dieser Quantisierungsfehlersignalwerte nahezu keinen Aufwand erfordert, ist nach einer weiteren Ausgestaltung der Erfindung dadurch gekennzeichnet, daß mit jedem Taktsignal der erste Eingang des ersten Addierers den mit einem Koeffizienten multiplizierten Quantisierungsfehlersignalwert aus dem Zuordner des Nachprädiktors und der zweite Eingang des ersten Addierers den mit dem gleichen Koeffizienten multiplizierten Eingangssignalwert aus dem entsprechenden Multiplizierer des Vorprädiktors erhält und daß der Teilprädiktor Multiplikationen mit der zweiten Anzahl Koeffizienten, die durch den in den Signalwerten des ersten Addierers enthaltenen Koeffizienten dividiert sind, ausführt. Da die Multiplikation sowohl des Eingangssignals als auch des Vorhersagefehlersignals mit demselben Koeffizienten erforderlich ist, können auf diese Weise ohnehin vorliegende Signale für den ersten Addierer verwendet werden.

4

Bei der Erzeugung jedes Vorhersagesignalwertes wird ein bestimmter Koeffizientensatz verwendet, der sich aus einer bestimmten Korrelation der Eingangssignale untereinander ergibt. Der optimale Koeffizientensatz, der also die kleinsten Vorhersagefehlersignale erzeugt, hängt jedoch auch von der tatsächlichen Folge der einzelnen Eingangssignalwert ab, und es ist daher bekannt, für eine Verringerung des Vorhersagefehlersignals mehrere Prädiktoren zu verwenden, die mehrere Vorhersagesignale mittels unterschiedlicher Koeffizientensätze erzeugen, und diese Vorhersagesignale abhängig von den zu verarbeitenden Eingangssignalwerten unterschiedlich zu gewichten und die gewichteten Vorhersagesignale zu einem Gesamt-Vorhersagesignal zu summieren, das der Differenzstufe und dem ersten Addierer zugeführt wird. Dieses Prinzip ist auch bei der vorliegenden Erfindung anwendbar, und ein Differenzpulscodemodulator mit adaptiver Prädiktion ist nach einer weiteren Ausgestaltung der Erfindung dadurch gekennzeichnet, daß mehrere einzelne Differenzpulscodemodulatoren vorgesehen sind, von denen das Ausgangssignal der ersten Kette über Multiplizierer zur Multiplikation mit einzelnen Gewichtsfaktoren, deren Summe gleich 1 ist, einem Summierer zugeführt sind, dessen Ausgangssignal das adaptive Vorhersagefehlersignal darstellt, das dem gemeinsamen Quantisierer und in jedem einzelnen Differenzpulscodemodulator dem Zuordner zugeführt ist. Da bei dem erfindungsgemäßen Differenzpulscodemodulator der Quantisierer außerhalb der Schleife liegt, wird die gewichtete Summierung auf die von den einzelnen Differenzpulscodemodulatoren erzeugten Vorhersagefehlersignale angewendet, und das Gesamt-Vorhersagefehlersignal wird dann zurückgekoppelt. Die Erzeugung der Gewichtsfaktoren für die Multiplizierer kann in an sich bekannter Weise erfolgen. Im Grenzfall können die Gewichtsfaktoren so erzeugt werden, daß sie nur den Wert Null oder Eins annehmen, d.h. es wird jeweils das Vorhersagefehlersignal nur eines der einzelnen Differenzpulscodemodulatoren ausgewählt und das Vorhersagefehlersignal der anderen vernachlässigt, und für diesen Fall ist es zweckmäßig, daß die Multiplizierer und der Summierer durch einen adaptiv gesteuerten Multiplexer ersetzt sind. Dies ergibt einen einfachen und schnellen Aufbau, da die Multiplizierer und der Summierer in der zeitkritischen Schleife liegen würden.

Eine weitere Möglichkeit, die Eigenschaften der Folge der Eingangssignale zu berücksichtigen, besteht darin, die Quantisierungskennlinie adaptiv anzupassen. Hierfür ist eine weitere Ausgestaltung der Erfindung dadurch gekennzeichnet, daß die Quantisierungskennlinie des Quantisierers und die Bildung der Produkte im Zuordner umschaltbar ist. Die Umschaltung der Zuordner ist erforderlich, weil darin auch implizit die Umwandlung des Vorhersagefehlersignalwerts in den Quantisierungsfehlersignalwert erfolgt, die sich bei der Umschaltung der Quantisierungskennlinie zwangsläufig ändert. Diese Maßnahme kann auch gemeinsam mit der vorher angegebenen adaptiven Prädiktion verwendet werden.

Die Erfindung bezieht sich ferner auf den Modulator selbst für das vorstehend angegebene System sowie auch auf den Demodulator, wie in den weiteren Unteransprüchen angegeben ist. Die Demodulation des quantisierten Vorhersagefehlersignals wird üblicherweise unter Verwendung eines Prädiktors vorgenommen, der ebenso wie der bei der Modulation verwendete Prädiktor aufgebaut ist, da ja im Modulator am Eingang des Prädiktors, d.h. am Ausgang des ersten Addierers, das rekonstruierte Signal entsteht. Aus diesem Grunde können die Demodulatoren aus einem Modulator gebildet werden, bei dem lediglich bestimmte Verbindungen unterbrochen werden, nämlich die Verbindung vom Eingang des Demodulators entweder zum Vorprädiktor sowie zum einen Eingang des Addierers oder zum subtrahierenden Eingang der Differenzstufe. Es kann somit eine einheitliche Schaltung hergestellt werden, die mit geringen Änderungen wie die genannten Verbindungen und der Inhalt der Zuordner als Modulator oder als Demodulator verwendet werden kann, was insbesondere bei Realisierung in Form einer integrierten Schaltung vorteilhaft ist.

Ausführungsbeispiele der Erfindung werden nachstehend anhand der Zeichnung näher erläutert. Es zeigen

Fig. 1 den prinzipiellen Aufbau eines bekannten Differenzpulscodemodulators,

Fig. 2 das prinzipschaltbild eines Differenzpulscodemodulators mit Aufteilung der Vorhersagewerte in einem System nach der Erfindung,

Fig. 3a und 3b nähere Einzelheiten bezüglich des Aufbaues eines Prädiktors bzw. des Vor-und Teilprädiktors der Anordnung nach Fig. 2 sowie des Aufbaues der darin verwendeten Multiplizierer,

Fig. 4 den ausführlicheren Aufbau eines Differenzpulscodemodulators in einem System nach der Erfindung, insbesondere hinsichtlich des Nachprädiktors,

Fig. 5 eine weiter ausgestaltete Ausführungsform der Anordnung nach Fig. 4, die weniger Aufwand erfordert,

Fig. 6 eine andere Ausgestaltung der Ausführungsform nach Fig. 4, bei der zusätzlich Verzögerungsstufen eingespart sind,

Fig. 7 die Folge der Signale, wenn diese bei der zeilenweisen Abtastung eines Bildes erzeugt werden,

5

Fig. 8 die vollständige Ausführungsform eines Differenzpulscodemodulators in einem System nach der Erfindung für die Verarbeitung derartiger Bildsignale,

Fig. 9 den grundsätzlichen Aufbau eines adaptiven Differenzpulscodemodulators nach dem Stand der Technik,

Fig. 10 den grundsätzlichen Aufbau eines adaptiven Differenzpulscodemodulators in einem System nach der Erfindung,

Fig. 11 den grundsätzlichen Aufbau eines Demodulators nach dem Stand der Technik,

Fig. 12 eine erste Ausführungsform eines Differenzpulscodemodulators in einem System nach der Erfindung, der aus einem Modulator nach Fig. 5 abgeleitet ist,

Fig. 13 eine zweite Auführungsform eines Differenzpulscodemodulators in einem System nach der Erfindung, der aus einem Modulator nach Fig. 5 abgeleitet ist.

Das erfindungsgemäße System besteht im wesentlichen aus einem Differenzpulsecodemodulator und einem Differenzpulscodedemodulator, zwischen denen in bekannter Weise eine Übertragungsstrecke oder ein Speicher angeordnet ist, deren Aufbau für die Erfindung nicht von Bedeutung ist und hier auch nicht näher erläutert wird. Ferner sind Modulator und Demodulator ähnlich aufgebaut, so daß zunächst nur der Modulator des erfindungsgemäßen Systems näher erläutert wird.

Die Fig. 1 stellt das prinzipschaltbild des bekannten Differenzpulscodemodulators dar und ist eingangs bereits erläutert worden. Wie aus dieser Figur zu erkennen ist, gelten für einzelne Signalwerte folgende Verhältnisse

$$e(n) = s(n) - s''(n) \text{ bzw. } s''(n) = s(n) - e(n) \qquad (1)$$
$$s'(n) = s''(n) + e'(n) \qquad (2)$$

Aus der Kombination dieser beiden Gleichungen ergibt sich

$$s'(n) = s(n) - e(n) + e'(n) \qquad (3)$$

Durch die Quantisierung des Vorhersagefehlersignalwerts $e(n)$ im Quantisierer 4 entsteht der Quantisierungsfehlersignalwert

$$q(n) = e'(n) - e(n) \qquad (4)$$

Da der quantisierte Vorhersagefehlersignalwert $e'(n)$ eine eindeutige Funktion des Vorhersagefehlersignalwerts $e(n)$ ist, ist auch der Quantisierungsfehlersignalwert $q(n)$ eine eindeutige Funktion des Vorhersagefehlersignals $e(n)$.

Durch Kombination der letzten beiden Gleichungen (3) und (4) ergibt sich

$$s'(n) = s(n) + q(n) \qquad (5),$$

und aus der Gleichung (4) folgt unmittelbar

$$e'(n) = e(n) + q(n) \qquad (6)$$

Daraus ist zu erkennen, daß im rekonstruierten Signal $s'$ derselbe Quantisierungsfehler $q$ auftritt wie im quantisierten Vorhersagefehlersignal $e'$.

In einem linearen Prädiktor, von dem im folgenden ausgegangen wird, wird der Vorhersagesignalwert $s''(n)$ nach folgender Gleichung gebildet:

$$s''(n) = \sum_{m=1}^{M} a_m \, s'(n-m) \qquad (7)$$

Für den gesuchten Vorhersagefehlersignalwert ergibt sich dann nach Gleichung (1):

$$e(n) = s(n) - \sum_{m=1}^{M} a_m \, s'(n-m) \qquad (8)$$

Jeder Vorhersagesignalwert $s''(n)$ wird also aus einer vorgegebenen Anzahl vorhergehender rekonstruierter Signalwerte $s'(n-m)$ gebildet, wobei jeder Signalwert mit einem entsprechenden Koeffizienten am multipliziert und alle Produkte aufsummiert sind. Dabei wird davon ausgegangen, daß die Eingangssignalwerte $s(n)$ linear mit der Zeit, d.h. mit einem Taktsignal aufeinanderfolgend, eintreffen. Falls die Eingangssignalwerte $s(n)$ zunächst zwei-oder mehrdimensional vorliegen, lassen sie sich praktisch immer in eine eindimensionale Folge umwandeln.

Bei derartigen Folgen, beispielsweise bei der Differenzpulscodemodulation der Bildpunkte eines zweidimensionalen Bildes für die Speicherung oder Übertragung, haben die Koeffizienten für mindestens eine Anzahl aufeinanderfolgender vergangener rekonstruierter Signalwerte den Wert Null, da die Korrelation der zugehörigen Eingangssignalwerte mit dem momentan betrachteten Eingangssignalwerte zu gering ist. Die folgenden Betrachtungen gelten im übrigen auch, wenn mehrere derartiger zeitlicher Lücken zwischen den Signalwerten, die tatsächlich für die Bildung des Vorhersagesignalwertes berücksichtigt werden, liegen, wobei zweckmäßig nur die erste solcher Lücken berücksichtigt und die folgenden Eingangssignalwerte bzw. Koeffizienten als eine zusammenhängende Folge betrachtet werden. Im einzelnen werden folgende Koeffizienten als Null angenommen:

$$a_i = O \text{ für } L+1 \leq i \leq K-1 \qquad (9)$$

Zwischen den Werten L und K liegt also eine zeitliche Lücke, d.h. die in diese Lücke zeitlich fallenden Eingangssignalwerte bzw. rekonstruierten Signalwerte werden für die Bildung des Vorhersagewertes $s''(n)$ nicht berücksichtigt, und die berücksichtigten Signalwerte bzw. Koeffizienten zerfallen also in zwei Gruppen.

In der Gleichung (8) wird nun die Summenbildung für diese zwei Gruppen getrennt geschrieben:

$$e(n) = s(n) - \sum_{m=1}^{L} a_m s'(n-m) - \sum_{m=K}^{M} a_m s'(n-m) \qquad (10)$$

Die zweite Teilsumme wird dabei aus zeitlich länger zurückliegenden rekonstruierten Signalwerten gebildet, wofür also genügend Zeit vorhanden ist, zumindest die Dauer der Lücke $T = K-L-1$. Zeitkritisch ist lediglich die erste Teilsumme, da gemäß Fig. 1 der rekonstruierte Signalwert erst ermittelt werden kann, wenn der zugehörige Vorhersagesignalwert vom Prädiktor erzeugt worden ist.

Diese erste Teilsumme wird nun gemäß Gleichung (5) aufgeteilt, so daß sich für den Vorhersagefehlersignalwert folgender Ausdruck ergibt:

$$e(n) = s(n) - \sum_{m=1}^{L} a_m s(n-m) - \sum_{m=1}^{L} a_m q(n-m) -$$

$$- \sum_{m=K}^{M} a_m s'(n-m) \qquad (11)$$

Oder vereinfacht geschrieben mit Vorzeichenumkehr, die für die später zu beschreibende Realisierung zweckmäßig ist:

$$-e(n) = s''_V(n) + s''_N(n) + s''_T(n) - s(n) \qquad (12)$$

mit

7

$$s''_V(n) = \sum_{m=1}^{L} a_m \, s(n-m) \qquad (13)$$

$$s''_N(n) = \sum_{m=1}^{L} a_m \, q(n-m) \qquad (14)$$

$$s''_T(n) = \sum_{m=K}^{M} a_m \, s'(n-m) \qquad (15)$$

Jeder Vorhersagesignalwert ist also in drei Teilsummen oder Vorhersageteilsignalwerte zerlegt worden, wobei der erste Vorhersageteilsignalwert $s''_V(n)$ direkt aus vergangenen Eingangssignalwerten ermittelt wird, so daß dafür praktisch beliebig viel Zeit zur Verfügung steht. Eine lange Berechnungszeit dafür äußert sich lediglich in einer langen konstanten Signaldurchlaufzeit. Die dritte Teilsumme, die als zweiter Vorhersage-teilsignalwert $s''_T(n)$ bezeichnet wird, entspricht der zweiten Teilsumme der Gleichung (10), für die also ebenfalls eine längere Bearbeitungszeit zur Verfügung steht, wenn eine ausreichend große zeitliche Lücke angenommen wird. Die mittlere Teilsumme $s''_N(n)$ ist eine Funktion der Quantisierungsfehlersignalwerte einer Anzahl unmittelbar vorhergehender Vorhersagefehlersignalwerte, wobei das Quantisierungsfehlersignal eine eindeutige Funktion des Vorhersagefehlersignals ist, wie früher erläutert wurde. Daher läßt sich jedes Produkt $a_m q(n-m)$ direkt aus dem betreffenden Vorhersagefehlersignalwert ermitteln.

Der Gleichung (12) entspricht die in Fig. 2 dargestellte Anordnung, bei der zunächst Verzögerungen durch Signalbearbeitungszeiten vernachlässigt sind. Die am Eingang 1 eintreffenden Eingangssignalwerte $s(n)$ werden der Differenzstufe 2, und zwar gemäß Gleichung (12) dem subtrahierenden Eingang, ferner einer als Vorprädiktor bezeichneten Einheit 12, um mit jedem Taktsignal einen ersten Vorhersageteilsignalwert $s''_V(n)$ zu erzeugen, sowie einem Eingang des ersten Addierers 6 zugeführt. Der andere Eingang des ersten Addierers 6 erhält den Quantisierungsfehlersignalwerte $q(n)$, der in einer Einheit 22 aus dem Vorhersagefehlersignalwert $e(n)$ gebildet wird, wie durch die strichpunktierte Linie angegeben ist. Die Einheit 22 kann ebenfalls ein Zuordner sein, der aus einem Speicher, der vom Vorhersagefehlersignalwert $e(n)$ adressiert wird, oder aus einer fest verdrahteten Logikschaltung besteht. Eine andere Möglichkeit besteht darin, den Quantisierungsfehlersignalwert $q(n)$ durch Bildung der Differenz zwischen dem Vorhersagefehlersignalwert $e(n)$ und dem quantisierten Vorhersagefehlersignalwert $e'(n)$ in einer Subtrahierstufe 20 zu bilden. Dem Subtrahierer 20 kann auch eine Verzögerungsstufe für eine Taktsignalzeit nachgeschaltet werden, um unmittelbar aufeinanderfolgende Additionsstufen zu vermeiden, wie später noch ausführlicher erläutert wird, da eine solche Verzögerung in dem weiteren, an den Ausgang des Addierers 6 anschließenden Signalweg sowie am anderen Eingang des Addierers berücksichtigt werden kann, wenn die zeitliche Lücke T größer ist als die für die Bildung des zweiten Vorhersageteilsignals erforderliche Zeit. Im übrigen wird später noch eine Lösung beschrieben, bei der weder ein Subtrahierer 20 noch eine gesonderte Einheit 22 erforderlich ist.

Der Ausgang des ersten Addierers 6, der mit jedem Taktsignal einen rekonstruierten Signalwert $s'(n)$ liefert, führt auf die Reihenschaltung einer Verzögerungsanordnung 18 und einer als Teilprädiktor bezeichneten Anordnung 14, die den zweiten Vorhersageteilsignalwert $s''_T(n)$ liefert. Der letzte Summand $s''_N(n)$ des Vorhersagesignalwerts $s''(n)$ wird von einer als Nachprädiktor bezeichneten Einheit 16 gebildet, die direkt vom Vorhersagefehlersignalwert $e(n)$ über die Leitung 3 angesteuert wird. Alle drei Summanden $s''_V(n)$, $s''_T(n)$ und $s''_N(n)$ werden in einem Summierer 10 summiert und ergeben den vollständigen Vorhersagesignal-wert $s''(n)$, der über die Leitung 9 der Differenzstufe 2 zugeführt wird, und zwar dem addierenden Eingang, wie in Gleichung (12) angegeben ist, so daß der negative Vorhersagefehlersignalwert $-e(n)$ erzeugt wird. Dieses Vorzeichen kann ohne weiteres im Quantisierer 4 sowie durch entsprechende Vorzeichen der Koeffizienten im Nachprädiktor 16 berücksichtigt werden. Die Einheiten 10 bis 18 bilden also den Prädiktor 8'.

Die Einheiten 12, 14 und 16 können in einer Weise aufgebaut sein, wie diese in Fig. 3a dargestellt ist. Darin wird das über den Eingang 29 zugeführte Signal parallel einer Anzahl Multiplizierer 30, 32 usw. bis 38 zugeführt, wo dieses Signal mit den entsprechenden Koeffizienten $a_L$, $a_{L-1}$, usw. bis $a_1$ multipliziert wird. Die Ausgänge der Multiplizierer 32 bis 38 führen auf den einen Eingang je eines Addierers 33 bis 37, dem jeweils eine Verzögerungsstufe 36 bis 39 nachgeschaltet ist. Jede dieser Verzögerungsstufen übernimmt mit jedem Taktsignal den an ihrem Eingang anliegenden Signalwert und stellt es am Ausgang bis zum nächsten Taktsignal zur Verfügung, so daß jede Verzögerungsstufe eine Verzögerung des Signals von einer Taktsignalzeit bewirkt. Die Kette aus jeweils einem Multiplizierer, einem Addierer und einer Verzögerungsstufe kann noch länger sein als dargestellt, wie durch die gestrichelten Linien angedeutet ist, abhängig von der Anzahl der Koeffizienten $a_m$. Der erste Addierer in der Kette, der bei systematischem Aufbau zwischen dem Ausgang des Multiplizierers 30 und der Verzögerungsstufe 31 liegen müßte, ist hier weggelassen worden, da er an seinem anderen Eingang ständig das Signal Null erhält und somit hier überflüssig ist. Bei anderen, später zu erläuternden Anordnungen, wo der Kette aus Addierern und Verzögerungsstufen ein weiteres Signal zur Addition zugeführt wird, ist ein solcher Addierer allerdings notwendig. Da schon wegen der Differenzbildung negative Signalwerte auftreten können, müssen die Addierer für die Verarbeitung solcher Signalwerte eingerichtet sein.

Zur Beschreibung der Funktion der Anordnung nach Fig. 3a wird angenommen, daß dem Eingang 29 ein Signalwert $x(n)$ zugeführt wird. Am Ausgang der Verzögerungsstufe 31 ist dann das Produkt des vorhergehenden Signalwerts $x(n-1)$ mit dem Koeffizienten $a_L$ vorhanden, d.h. der Signalwert $a_L x(n-1)$. Dazu wird in dem Addierer 33 das Produkt aus dem Signalwert $x(n)$ und dem Koeffizienten $a_{L-1}$ addiert, so daß am Ausgang des Addierers 33 der Signalwert $a_{L-1} x(n) + a_L x(n-1)$ vorhanden ist. Dies setzt sich Stufe für Stufe in der Kette mit fortschreitender Verzögerung fort, so daß am Ausgang des Addierers 37 schließlich der Signalwert

$$a_1 x(n) + \ldots + a_{L-1} x(n-L+2) + a_L x(n-L+1)$$

vorhanden ist. Am Ausgang der Verzögerungsstufe 39 erscheint also der mit dem Koeffizienten $a_L$ multiplizierte, am frühesten zugeführte Signalwert mit einer der Anzahl Koeffizienten gleichen Anzahl Taktzeiten Verzögerung. Der mit dem Koeffizienten $a_1$ multiplizierte Signalwert ist dagegen nur um eine Taktzeit verzögert.

Dabei ist die Verzögerungszeit in den einzelnen Multiplizierern 30, 32 bis 38 vernachlässigt. Eine solche auftretende Verzögerung, die in allen Multiplizierern gleich ist, äußert sich jedoch lediglich in einer zusätzlichen Verlängerung der Signallaufzeit durch die Anordnung. Da für den Vorprädiktor 12 und den Teilprädiktor 14 in Fig. 2 eine längere Bearbeitungszeit zur Verfügung steht, können die Multiplizierer 30, 32 bis 38 in der in Fig. 3b dargestellten Weise aufgebaut sein. Dabei wird die Multiplikation durch eine durch den Multiplikator bestimmte Anzahl stellenverschobener Additionen des Multiplikanden durchgeführt. Der Multiplikand wird über den Eingang 29 dem einen Eingang eines Addierers 42 zugeführt, der am anderen Eingang den Multiplikanden um eine dem Abstand zwischen z.B. den beiden niedrigstwertigen Stellen mit dem Wert Eins des Multiplikators entsprechende Anzahl Stellen verschoben erhält, wobei diese Stellenverschiebung durch den Block 41 angedeutet ist. Danach wird der Multiplikand in einer Verzögerungsstufe 43 und die erste Teilsumme in einer Verzögerungsstufe 44 zwischengespeichert, deren Ausgänge direkt bzw. im Block 45 stellenverschoben mit einem Addierer 46 verbunden sind. Durch die Verzögerungsstufen 43 und 44 mit je einer Taktzeit muß innerhalb dieser Taktzeit nur eine Addition zweier Zahlen durchgeführt werden, so daß für die Addierer relativ langsame Elemente verwendet werden können. Diese Zwischenspeicherung und stellenverschobene Addition wird weitergeführt, bis alle von Null verschiedenen Stellen des Multiplikators berücksichtigt sind. Am Ausgang des Verzögerungsgliedes 52 entsteht also das Produkt eines über den Eingang 29 zuge führten Signals als Multiplikanden mit einem durch die Stellenverschiebungen in den Blöcken 41, 45 bis 49 dargestellten Multiplikators mit einer Verzögerung von einer Anzahl Taktzeiten, die um eine weniger ist als die Anzahl der Einsen im Multiplikator. Zur Verkürzung der Anzahl der Stufen kann es auch zweckmäßig sein, einzelne Addierer durch Subtrahierer zu ersetzen. In jedem Fall müssen auch hier die Addierer zur Verarbeitung negativer Signalwerte eingerichtet sein. Um eine vorgegebene Verzögerungszeit, die durch den Multiplizierer mit der größten Stufenzahl bestimmt ist, zu erreichen, können der Verzögerungsstufe 52 noch weitere Verzögerungsstufen nachgeschaltet werden. Wenn die niedrigstwertige Stelle im Multiplikator keine 1 ist, kann das Signal dem Eingang 29 bereits entsprechend stellenverschoben zugeführt werden, oder die Stellenverschiebung wird am Ausgang vorgenommen. Die Multiplikation mit stellenverschobener Addition gemäß Fig. 3b kann jedoch nur im Vorprädiktor 12 und im Teilprädiktor 14 der Anordnung nach Fig. 2 angewendet werden, da im Nachprädiktor 16 für die Verarbeitung des zuletzt aufgetretenen Vorhersagefehlersignalwerts für den nächsten Vorhersagesignalwert nur eine Taktzeit zur Verfügung steht. Außerdem sind in Fig. 2 zwei arithmetische Bearbeitungen in dem Summierer und der Differenzstufe 2 unmittelbar hintereinandergeschaltet, was aus Geschwindigkeitsgründen ebenfalls nicht günstig ist.

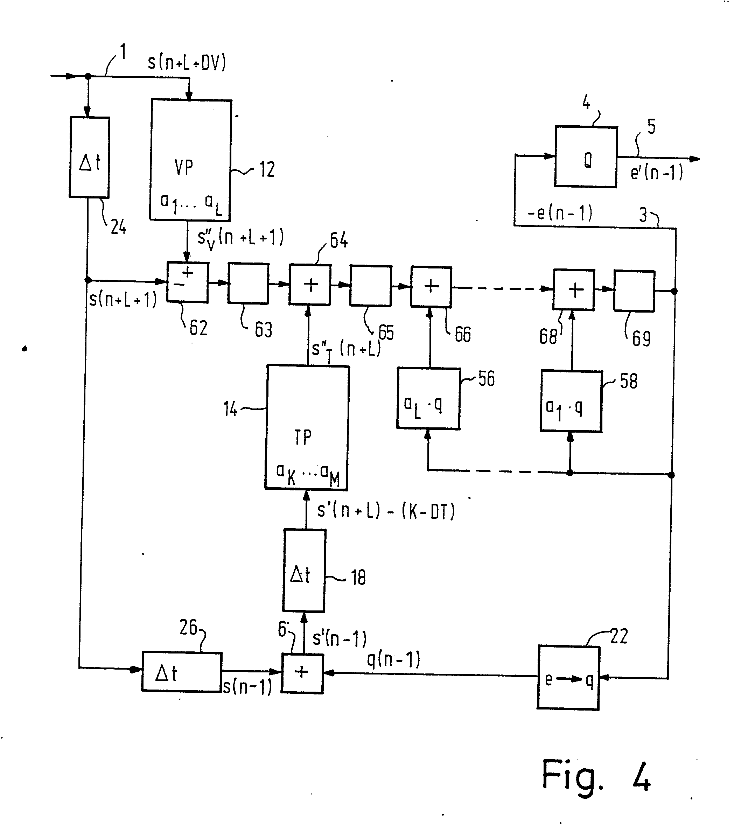

Eine Anordnung, bei der in jeder Taktzeit nur eine arithmetische Verarbeitung zweier Signalwerte und zusätzlich höchstens ein Speicherzugriff durchgeführt werden muß, ist in Fig. 4 dargestellt. Dabei sind die beiden Stufen 2 und 10 in Fig. 2 auf eine Kette von einer Differenzstufe 62, einem Addierer 64 und dem ersten Addierer 66 im Nachprädiktor aufgeteilt, denen jeweils eine Verzögerungsstufe 63 bzw. 65 nachgeschaltet ist. Der Nachprädiktor ist in der anhand der Fig. 3a beschriebenen Weise aus einer Kette von Addierern und Verzögerungsstufen aufgebaut, wobei gegenüber der Fig. 3a der erste Addierer der Kette nicht weggelassen ist, sondern die Kette beginnt in Fig. 4 mit dem Addierer 66, wobei die diesem nachgeschaltete Verzögerungsstufe bereits der übersichtlichkeit halber nicht mehr dargestellt ist, und endet mit dem Addierer 68 und der nachgeschalteten Verzögerungsstufe 69, die das Ende der Kette bildet. Die unteren Eingänge der Addierer 66 bis 68 erhalten die Ausgangssignale eines Zuordners, der hier z.B. einzelne Festwertspeicher 56 bis 58 enthält, die direkt von dem Vorhersagefehlersignal e (genauer: -e, wie bei Fig. 2 erläutert wurde) auf der Leitung 3 adressiert werden und an jeder Adresse den Wert des Produktes des zu diesem Vorhersagefehlersignal e gehörigen Quantisierfehlersignals q und des jeweiligen Koeffizienten $a_1$ bis $a_L$ enthält. Außerdem wird das Vorhersagefehlersignal e auf der Leitung 3 dem Quantisierer 4 zugeführt, der ebenfalls ein Zuordner, z.B. in Form eines Festwertspeichers sein kann, der an jeder Adressenstelle das zugehörige quantisierte Fehlersignal e' bzw., wie früher bereits erwähnt, die kodierte Quantisierungsstufennummer enthält, sowie einem weiteren Zuordner 22, der für jeden Vorhersagefehlersignalwert e(n) den Quantisierfehlersignalwert q erzeugt.

Wie aus Fig. 4 zu erkennen ist, ist innerhalb einer Taktsignalzeit nur ein Zugriff auf die in diesem Beispiel als Speicher 56 bis 58 ausgeführten Zuordner und die Addition der aus diesen Speichern ausgelesenen Signalwerte in den Addierern 66 bis 68 zu den gleichzeitig an den linken Eingängen zugeführten Signalwerten erforderlich, damit mit dem nächsten Taktsignal diese Summe in die jeweils nachgeschaltete Verzögerungsstufe übernommen werden kann, wobei gleichzeitig der nächste Zugriff auf die Speicher 56 bis 58 erfolgt, usw.

Zu dem in der Kette aus den Elementen 66 bis 69 erzeugten Signal des Nachprädiktors muß nun die Differenz aus dem zeitrichtig zugehörigen Eingangssignal s und der Summe der beiden Vorhersageteilsignale $s''_V$ und $s''_T$ von Vorprädiktor und Teilprädiktor addiert werden, was am Ende der Kette der Elemente 66 bis 69 des Nachprädiktors geschehen könnte. Dann wäre jedoch eine Stufe zur Verarbeitung von mehr als zwei Signalen gleichzeitig oder eine Kette von mehreren Verarbeitungsstufen ohne Verzögerungsglied dazwischen erforderlich, denn nach dem Addierer 68 darf nur eine einzige Verzögerungsstufe folgen, damit dieser Addierer 68 jeweils den von dem gerade vorhergehenden Vorhersagefehlersignalwert abgeleiteten Signalwert an seinem unteren Eingang empfängt. Da jedoch auch bei der Verarbeitung von Signalen die Reihenfolge von Additionen bzw. Subtraktionen beliebig ist, wenn keine anderen Operationen vorgenommen werden, wird hier nun das aus dem Eingangssignal s und den beiden Vorhersageteilsignalen $s'_V$ und $s''_T$ gebildete Zwischensignal dem linken Eingang des Addierers 66 zugeführt, wodurch jedoch eine Verzögerung jedes Zwischensignalwerts bis zum Ausgang des Verzögerungsglieds 69 erfolgt. Diese Verzögerung wird dadurch berücksichtigt, daß dem linken Eingang des Addierers 6 eine Verzögerungsanordnung 26 vorgeschaltet ist, die die zugeführten Eingangssignalwerte s(n) verzögert. Auch die Verzögerung, die beispielsweise für die Eingangssignalwerte beim Durchlaufen der Verzögerungsstufen 63 und 65 bis zum Eingang des Addierers 66 hervorgerufen wird, muß dabei berücksichtigt werden, ebenso wie die Verzögerungsstufe 65 bei der Gesamtverzögerung der Signalwerte im Teilprädiktor 14 und der in diesem Beispiel vorgeschalteten Verzögerungsanordnung 18 berücksichtigt werden muß, während die durch die Multiplizierer im Vorprädiktor 12 entstehende Verzögerung durch die Verzögerungsanordnung 24 berücksichtigt wird.

Um die einzelnen Verzögerungen genauer zu übersehen, sind in Fig. 4 an einzelnen Leitungen die zu bestimmten Zeitpunkten gehörenden Signalwerte angegeben, wobei der Vorhersagefehlersignalwert e(n-1) auf der Leitung als Bezugszeitpunkt dienen möge. Dabei bedeutet (n-1) einen willkürlichen Zeitpunkt. Da im Nachprädiktor die Kette aus den Elementen 66 bis 69 genau L Verzögerungsstufen mit einer Verzögerung von je einer Taktzeit enthält, nämlich für jeden Koeffizienten $a_m$ eine Verzögerungsstufe, wie aus Fig. 4 leicht zu erkennen ist, gehört der zu diesem Zeitpunkt am linken Eingang des Addierers 66 anliegende Signalwert, bezogen auf die Leitung 3, zum Zeitpunkt (n+L-1). Dadurch muß am Ausgang des Teilprädiktors 14 der zweite Vorhersageteilsignalwert $s''_T(n+L)$ anstehen, um die Verzögerung in der Verzögerungsstufe 65 zu berücksichtigen. Entsprechend sind an den Eingängen der Differenzstufe 62 die

Signalwerte $s''_V(n+L+1)$ und $s(n+L+1)$ erforderlich. Da letzterer Signalwert gleichzeitig auch am Eingang der Verzögerungsanordnung 26 liegt, muß diese eine Verzögerung von $D_{26}=L+2$ Taktzeiten haben, damit dem linken Eingang des Addierers 6 der bezogen auf den am rechten Eingang anliegenden Signalwert q(n-1) zeitrichtige Signalwert s(n-1) zugeführt wird.

Jeder Signalwert $s''_T(n+L)$ am Ausgang des Teilprädiktors 14 wird aus Signalwerten gebildet, von denen der zeitlich letzte zu einem Zeitpunkt gehört, der gemäß Gleichung (15) K Taktzeiten vor dem Zeitpunkt des Signalwerts am Ausgang liegt, also zum Zeitpunkt (n+L-K) gehört. Da zwischen dem Ausgang des Teilprädiktors 14 und dem Eingang der Verzögerungsanordnung 18 insgesamt $L+1$ Verzögerungsstufen liegen, muß die Gesamtverzögerung von Teilprädiktor 14 und Verzögerungsanordnung 18 insgesamt K-L-1 Taktzeiten sein. Wenn im Teilprädiktor 14 durch eine gemäß der Fig. 3b durchgeführte Multiplikation eine Verzö gerung von $D_{14}=DT$ Taktzeiten erzeugt wird, d.h. der letzte für das Ausgangssignal $s''_T(n+L)$ verwendete Signalwert ist $s'((n+L)-(K-DT))$, muß also die Verzögerungsanordnung 18 eine Verzögerungszeit von $D_{18}=K-L-DT-1=T-DT$ Taktzeiten haben. Übrigens ergibt sich aus der Tatsache, daß die Verzögerungszeit dieser Verzögerungsanordnung 18 minimal Null sein kann, daß die zeitliche Lücke zwischen den beiden Gruppen von Signalen, die zur Bestimmung des Fehlersignals e auf der Leitung 3 verwendet werden, mindestens so groß sein muß wie die Gesamtverzögerung DT im Teilprädiktor 14.

Wenn die Verzögerungszeit im Vorprädiktor 12 zwischen dessen Ausgangssignalwert $s''_V(n+L+1)$ und dem zeitlich letzten dafür verwendeten Eingangssignalwert aufgrund der entsprechend Fig. 3b durchgeführten Multiplikation mit DV angenommen wird, muß die Verzögerungszeit $D_{24}$ der Verzögerungsanordnung 24 gerade $D_{24}=DV-1$ Taktzeiten sein, damit am subtrahierenden Eingang der Differenzstufe 62 ein bestimmter Eingangssignalwert s(n+L+1) und am anderen Eingang der aus den unmittelbar vorhergehenden Eingangssignalwerten gebildete erste Vorhersageteilsignalwert $s''_V(n+L+1)$ vorhanden sind.

Es ist also leicht zu erkennen, daß bei verschiedenen Anwendungsfällen, d.h. bei verschiedenen Werten für L und K, die entsprechenden Verzögerungen in den Verzögerungsanordnungen 18, 24 und 26 berücksichtigt werden können, zumindest unter Berücksichtigung der vorher genannten Einschränkung für die minimale Dauer der zeitlichen Lücke.

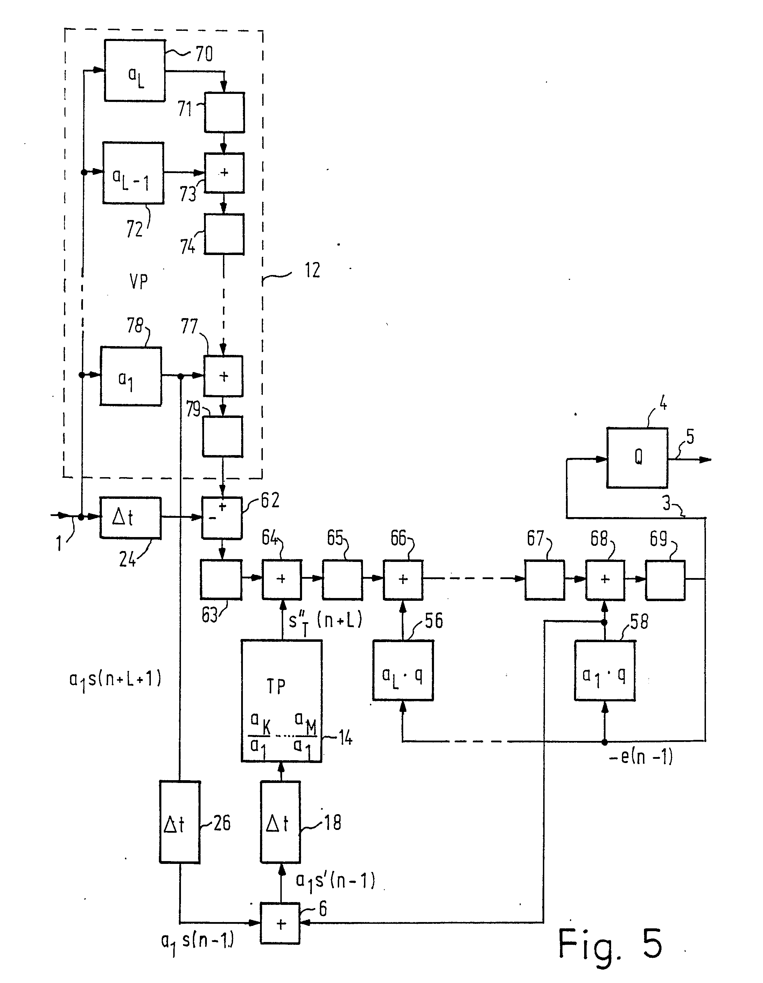

In Fig. 5 ist eine Anordnung dargestellt, bei der gegenüber der Anordnung nach Fig. 4 der Umsetzer 22 vom Vorhersagefehlersignal in das Quantisierfehlersignal eingespart ist. Dazu wird die Tatsache ausgenutzt, daß bereits die Zuordner 56 bis 58 eine derartige Umsetzung vornehmen, allerdings zusätzlich noch multiplikativ verknüpft mit dem Wert des entsprechenden Koeffizienten $a_m$. Wie man jedoch anhand der Fig. 5, in der der Vorprädiktor 12 ausführlicher gemäß Fig. 3a dargestellt ist, erkennt, wird in diesem Vorprädiktor ebenfalls das Produkt des Eingangssignals mit jedem dieser Koeffizienten $a_1$ bis $a_L$ erzeugt. Wenn nun die Eingänge des Addierers 6 mit dem Ausgang eines der Zuordner 56 bis 58, beispielsweise wie dargestellt mit dem Ausgang des Zuordners 58, und mit dem entsprechenden Ausgang des Multiplizierers 78 im Vorprädiktor 12, hier über die Verzögerungsanordnung 26, verbunden werden, entsteht am Ausgang des Addierers 6 das rekonstruierte Signal mit dem entsprechenden Koeffizienten multipliziert, nämlich $a_1 s'$. Dieser Koeffizient $a_1$ beim rekonstruierten Signal s' bildet jedoch keine Schwierigkeit, da er bei den Koeffizienten $a_K$ bis $a_M$ des Teilprädiktors 14 berücksichtigt werden kann, d.h. der Teilprädiktor 14 führt Multiplikationen mit den Faktoren $a_K/a_1$ bis $a_M/a_1$ durch. Damit entsteht am Ausgang des Teilprädiktors 14 wieder das richtige zweite Vorhersagesignal $s''_T$. Die notwendigen Verzögerungen der Verzögerungsanordnungen 18, 24 und 26 sind dabei nicht verändert, es ist lediglich deutlicher zu sehen, daß die Verzögerungszeit der Verzögerungsanordnung 24 gleich der Verzögerungszeit jedes der Multiplizierer 70 bis 78 im Vorprädiktor 12 ist, da dessen Gesamtverzögerungszeit um die Verzögerungsstufe 79 länger ist.

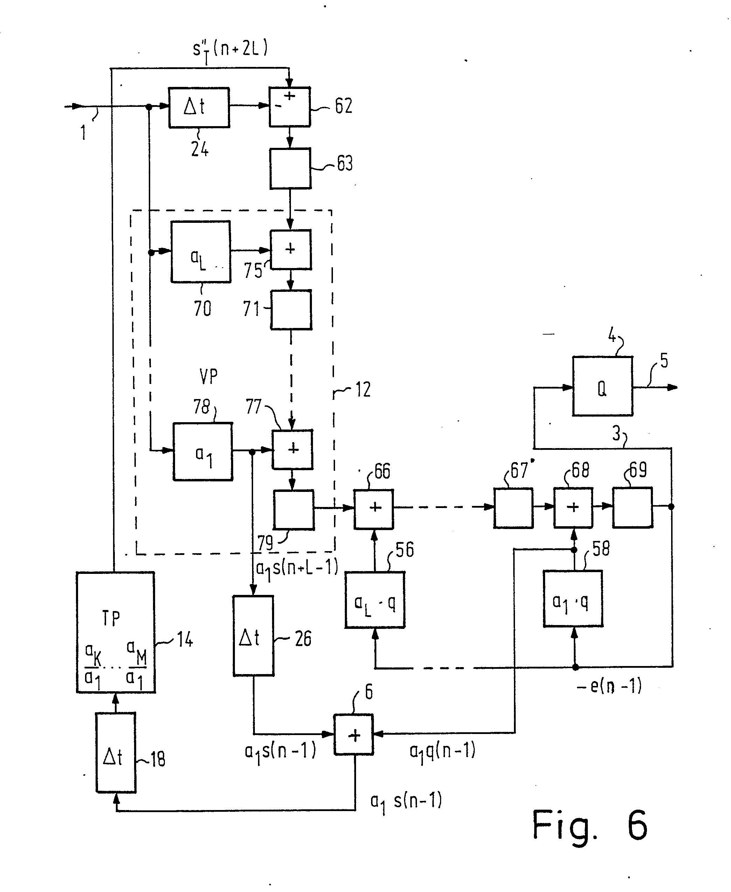

Wie vorher ausgeführt wurde, muß bei den Anordnungen nach Fig. 4 bzw. Fig. 5 die zeitliche Lücke T zwischen den Signalen, die zur Prädiktion verwendet, mindestens so groß sein wie die Verzögerungszeit des Teilprädiktors 14. In vielen Anwendungsfällen ist diese zeitliche Lücke jedoch wesentlich größer, insbesondere kann für die Lücke T L+DT angenommen werden, und außerdem ist im Vorprädiktor die bereits erwähnte Verzögerungszeit DV L+2, und in diesem Falle kann zur Einsparung von Verzögerungselementen in der Verzögerungsanordnung 18 die Anordnung nach Fig. 6 verwendet werden. Dabei wird das Ausgangssignal des Teilprädiktors 14, d.h. das zweite Vorhersagesignal $s''_T$, dem Eingang der Kette aus Addierern und Verzögerungsstufen im Vorprädiktor 12 zugeführt, die dabei um den Addierer 75 am Anfang ergänzt ist, und auf diese Weise die Summe der Verzögerungszeiten der Verzögerungsstufen 71 bis 79 im Vorprädiktor 12 für dieses zweite Vorhersageteilsignal verwendet. Außerdem ist hier angenommen, daß die Verzögerungszeit jedes Multiplizierers 70 bis 78 im Vorprädiktor 12 mindestens um 1 größer ist als die erste Anzahl L von Koeffizienten, so daß die Differenzstufe 62 mit der nachfolgenden Verzögerungsstufe 63 nun vor den Teilprädiktor 12 verlegt worden ist und der nachfolgende Addierer 64 mit der Verzögerungsstufe 65 wegfällt. In diesem Falle ist auch die Verzögerungszeit der Verzögerungsanordnung 24 kürzer als bei der Anordnung nach Fig. 5, nämlich es ist $D_{24} = DM-L-1$ mit DM gleich der Verzögerungszeit der Multiplizierer 70 bis 78. Da der Ausgang des Vorprädiktors 12, d.h. der Ausgang der Verzögerungsstufe 79, nun unmittelbar auf den linken Eingang des ersten Addierers 66 des Nachprädiktors führt, so daß die Verzögerungsstufen 63 und 65 der Anordnung nach Fig. 5 nicht mehr in diesem Signalweg liegen, ist die Verzögerungszeit der Verzögerungsanordnung 26 entsprechend kürzer, nämlich $D26 = L$. Da zwischen dem linken Eingang des Addierers 66 und dem Ausgang des Teilprädiktors 14 nunmehr nicht nur eine Verzögerungsstufe, nämlich hier die Verzögerungsstufe 63, sondern die L Verzögerungsstufen des Teilprädiktors 12 zusätzlich liegen, ist die Verzögerungsdauer der Verzögerungsanordnung 18 nunmehr

$D_{18} = K-2L-DT-1 = T-DT-L$.

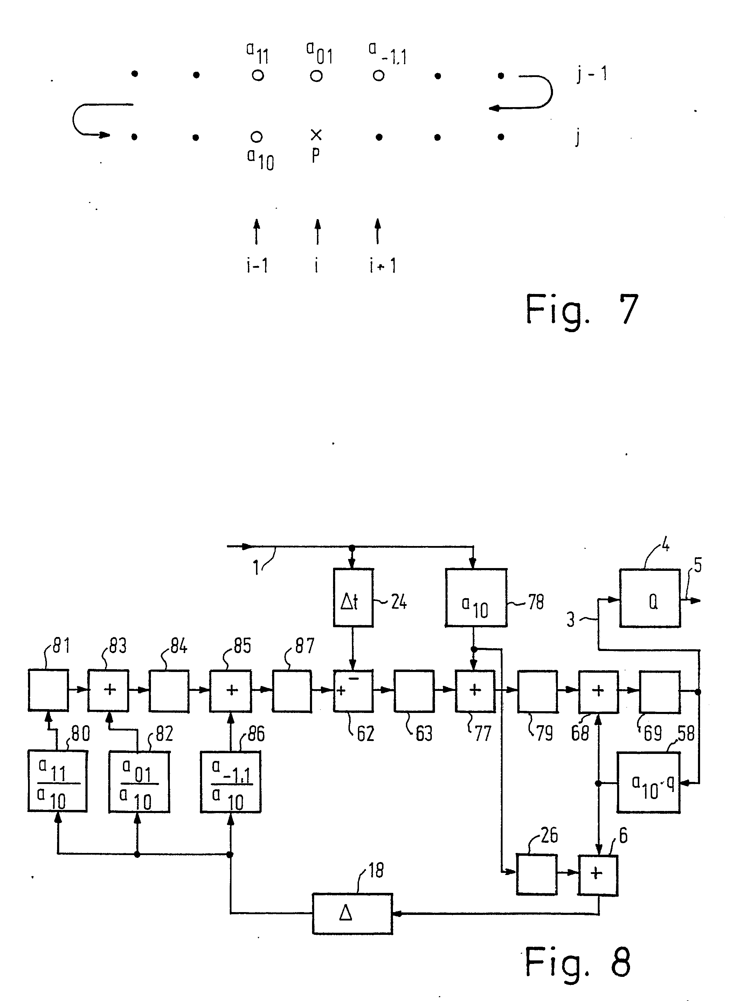

Die zu verarbeitenden Eingangssignale können aus verschiedenen Quellen kommen. Ein sehr häufiger Anwendungsfall ist die Erzeugung der Eingangssignale aus der zeilenweisen Abtastung eines zweidimensionalen Bildes. In Fig. 7 sind ein Teil zweier aufeinanderfolgender Zeilen, nämlich die Zeile j-1 und j, angedeutet, die zeilenweise abgetastet werden, wie durch die Pfeile angegeben ist. Zur Bestimmung des Vorhersagewertes $s''_{i,j}$ für den punkt p in der Spalte bzw. Reihe i und der Zeile j werden gemäß der Gleichung für den zugehörigen Bildsignalwert

$$s''_{i,j} = \sum_n \sum_m a_{n,m} s'(i-n, j-m)$$

die Bildsignalwerte der im Bild benachbarten vier Bildpunkte, die bei der Bildabtastung vorher bereits aufgetreten sind und die in Fig. 7 mit den zugehörigen Prädiktionskoeffizienten $a_{11}$, $a_{01}$, $a_{-1,1}$ und $a_{10}$ bezeichnet sind, verwendet, wobei die Indizes aus den drei Reihen i-1, i und i+1 und den beiden Zeilen j-1 und j, in denen die zur Prädiktion verwendeten Bildpunkte enthalten sind, gebildet sind. Bezogen auf die in den vorhergehenden Figuren verwendeten Indizes gilt folgendes:

$L = 1$, $K = B-1$, $M = B+1$

mit B gleich der Gesamtzahl der Bildpunkte pro vollständiger abgetasteter Bildzeile. Die Anordnung nach Fig. 6 vereinfacht sich bei diesen Werten zu der in Fig. 8 dargestellten Anordnung, bei der der Teilprädiktor 14 der Fig. 6 aus den Multiplizierern 80, 82 und 86, den Addierern 83 und 85 und den Verzögerungsstufen 81, 84 und 87 besteht. Die Verzögerungszeit der Verzögerungsanordnung 24 ist um zwei Taktzeiten kürzer als die Verzögerung des Multiplizierers 78, der zusammen mit dem Addierer 77 und dem Verzögerungsglied 79 den Vorprädiktor bildet. Entsprechend enthält der Nachprädiktor lediglich den Zuordner 58 und den Addierer 68 sowie die Verzögerungsstufe 69, und die Verzögerungsanordnung 26 besteht lediglich aus einer einzigen Verzögerungsstufe. Die Verzögerungszeit der Verzögerungsanordnung 18 ist um fünf Taktzeiten und die Verzögerungszeit DM jedes der Multiplizierer 80, 82, 86 kürzer als die Anzahl Bildpunkte einer vollständig abgetasteten Bildzeile, also $D_{18} = B-5-DM$. Außer dem Quantisierer 4 ist nur ein weiterer Zuordner 58 erforderlich, und es werden vier Multiplizierer 78, 80, 82 und 86 mit dem Aufbau gemäß Fig. 3b benötigt, wobei die verwendeten Koeffizienten in den Blöcken angegeben sind. Da jeder dieser Multiplizierer in den meisten Anwendungsfällen nur wenige Addierer und Verzögerungsstufen enthält, läßt sich die in Fig. 8 dargestellte Anordnung leicht als integrierte Schaltung ausführen, insbesondere außer den z.B. als Speicher ausgeführten Zuordnern 4 und 58 und der Verzögerungsanordnung 18 wegen der für die übrigen Teile entstehenden regelmäßigen Struktur aus Addierern und Verzögerungsstufen als Gate-Array.

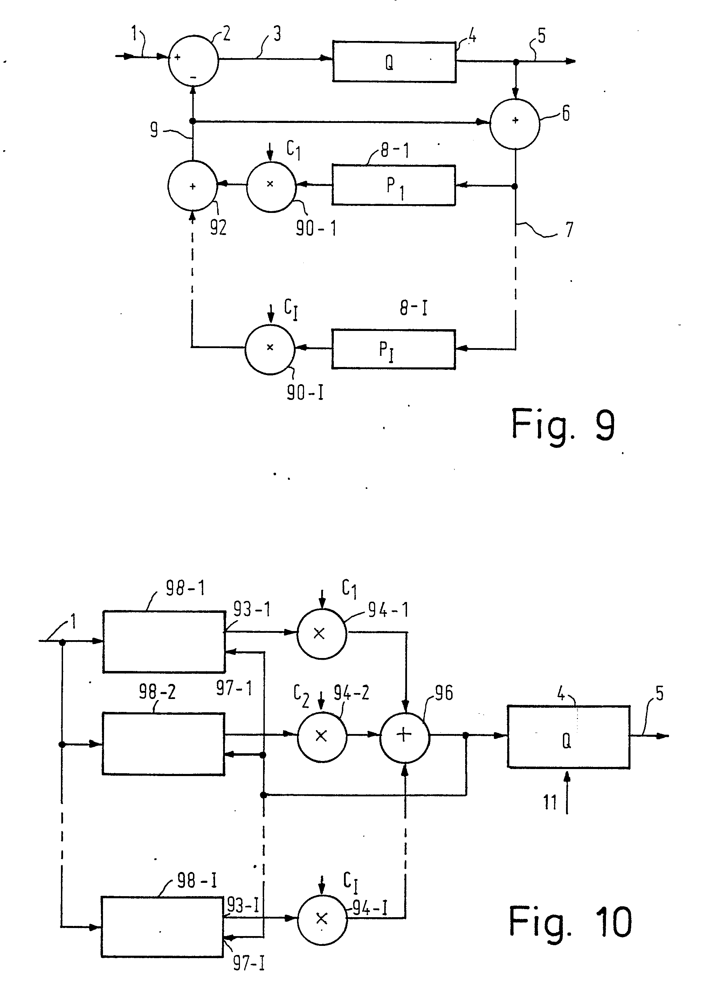

Für eine noch wirksamere Informationsreduzierung ist es bekannt, einen adaptiven Differenzpulscodemodulator zu verwenden, wie er in Fig. 9 angedeutet ist. Dieser ist im wesentlichen wie die Anordnung in Fig. 1 aufgebaut, verwendet jedoch mehrere Prädiktoren 8-1 bis 8-I, die alle dasselbe rekonstruierte Signal über die Leitung 7 vom Addierer 6 erhalten, jedoch durch Verwendung unterschiedlicher Koeffizientensätze unterschiedliche Vorhersagewerte bestimmen. Diese unterschiedlichen Vorhersagewerte werden Multiplizierern 90-1 bis 90-I zugeführt, wo sie mit Gewichtungsfaktoren $C_1(n)$ bis $C_I(n)$ multipliziert werden. Die Bestimmung dieser Gewichtsfaktoren $C_1(n)$ bis $C_I(n)$ erfolgt in an sich bekannter Weise und wird daher hier nicht näher erläutert, da es für die Erläuterung der Erfindung nicht wesentlich ist. Die an den Ausgängen der Multiplizierer 90-1 bis 90-I erzeugten gewichteten Vorhersagewerte werden in einer Summierstufe 92 zu einem Gesamt-Vorhersagewert an deren Ausgang 9 aufsummiert. Wegen des grundsätzlich etwas abweichenden Aufbaues des erfindungsgemäßen Differenzpulscodemodulators, bei dem mehrere Vorhersageteilsignale innerhalb des Prädiktors erzeugt werden, läßt sich die in Fig. 9 dargestellte Struktur nicht ohne weiteres übertragen. Eine Lösung dieses Problems ist in Fig. 10 dargestellt, die ebenfalls eine Anzahl Anordnungen 98-1, 98-2 bis 98-I verwendet, die entsprechend den Fig. 2 bzw. 4 bis 6 oder 8 aufgebaut sind, mit einer kleinen Änderung der Verbindungen. Es wird nämlich jeweils das Vorhersagefehlersignal e am Ausgang der Differenzstufe 2 in Fig. 2 bzw. am Ausgang des Nachprädiktors, d.h. der Verzögerungsstufe 69 in den Fig. 4 bis 6 und 8 über jeweils einen eigenen Ausgang 93-1 bis 93-I herausgeführt und Multiplizierern 94-1 bis 94-I zugeführt, wo diese Vorhersagefehlersignale mit den Gewichtskoeffizienten $C_1(n)$ bis $C_I(n)$ multipliziert werden, wobei

$$\sum_{i=1}^{I} C_i(n) = 1$$

sein muß. Die einzelnen Vorhersagefehlerteilsignale werden in einem Summierer 96 zusammengefaßt zu einem Gesamt-Vorhersagefehlersignal, das einerseits direkt dem Quantisierer 4 zugeführt wird, andererseits aber auch Eingängen 97-1 bis 97-I der Anordnungen 98-1 bis 98-I. Diese Eingänge führen auf den Nachprädiktor 16 in Fig. 2 bzw. die Zuordner mit dem Speicher 58 und gegebenenfalls den weiteren Speichern wie dem Speicher 56 in den Fig. 4 bis 6 und dem Speicher 22 in Fig. 4. Das bedeutet, daß für die prädiktion in jeder Anordnung außer den über den Eingang 1 zugeführten Eingangssignalen das Gesamt-Vorhersagefehlersignal am Ausgang des Summierers 96 und nicht das jeweils erzeugte Vorhersagefehlerteilsignal am Ausgang 93 verwendet wird.

Da die Multiplizierer 94 und der Summierer 96 nun aber zusätzlich in der zeitkritischen Schleife liegen, müssen dafür sehr schnelle Bauelemente verwendet werden. In vielen Fällen ist jedoch eine besonders genaue Bestimmung der einzelnen Gewichtungsfaktoren $C_1(n)$ bis $C_I(n)$ nicht erforderlich, sondern diese brauchen nur den Wert Null oder Eins zu haben, d.h. es wird jeweils nur eines der von den Anordnungen 98-1 bis 98-I erzeugten Vorhersagefehlersignale ausgewählt. Damit reduziert sich jeder der Multiplizierer 94-1 bis 94-I zu einem einfachen Schalter, und der Summierer 96 reduziert sich zu éinem Verbindungspunkt ohne Verknüpfung, d.h. die Anordnung aus den Multiplizierern 94-1 und 94-I und dem Summierer 96 wird durch einen Multiplexer ersetzt, der keine wesentliche Durchlaufverzögerung aufweist. Zusätzlich oder anstelle der beschriebenen adaptiven Prädiktion kann die Quantisierungskennlinie des Quantisierers 4 über den Steuereingang 11 angepaßt werden, wobei auch eine entsprechende Anpassung der Zuordner 56, 58 in den einzelnen Anordnungen 98-1 usw. erforderlich ist, zweckmäßig mit demselben Steuersignal. Beispielsweise kann bei Verwendung von Speichern für den Quantisierer und die Zuordner der jeweilige Speicherbereich über den Steuereingang 11 umgeschaltet werden.

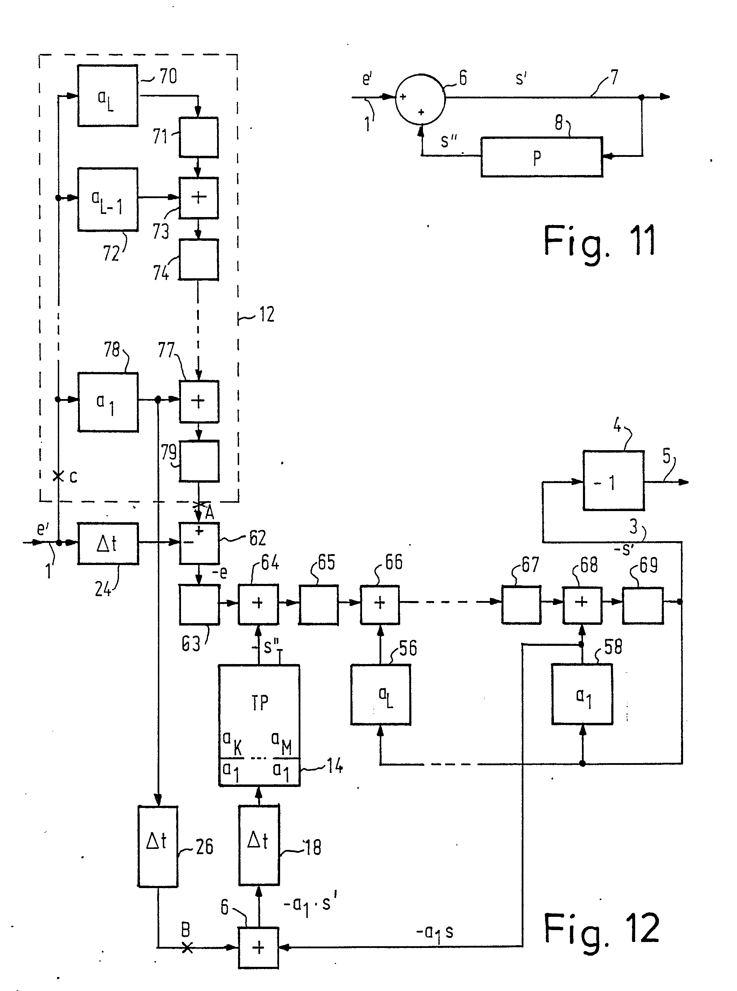

Zur Demodulation der quantisierten Vorhersagefehlersignale e', d.h. zur Gewinnung der rekonstruierten Signale, kann ein Demodulator mit dem gleichen Prädiktor wie im Modulator verwendet werden, wie aus Fig. 1 leicht zu erkennen ist. Das rekonstruierte Signal s' entsteht am Ausgang des Addierers 6, der das quantisierte Vorhersagefehlersignal e' und das im Prädiktor 8 aus dem rekonstruierten Signal s' erzeugte Vorhersagesignal s erhält. Dies führt zu einer Anordnung, die in Fig. 11 dargestellt ist und lediglich den Addierer 6 und den Prädiktor 8 enthält. Über den Eingang 1 wird dabei das quantisierte Vorhersagefehlersignal e' zugeführt und von der Ausgangsleitung 7 des Addierers 6 das rekonstruierte Signal s' abgenommen.

In entsprechender Weise ist es möglich, für den Demodulator in dem System die Anordnungen nach Fig. 2 bzw. 4 bis 6 oder 8 im wesentlichen unverändert zu verwenden, es müssen lediglich bestimmte Verbindungen darin aufgetrennt bzw. die Eingänge bestimmter Elemente ständig den Wert Null erhalten und die Inhalte der Zuordner mit den Speichern 56 bis 58 angepaßt werden. Eine mögliche Ausführungsform des Demodulators entsprechend der Anordnung nach Fig. 5 ist in Fig. 12 dargestellt. Darin sind an den Stellen A und B die Verbindungen unterbrochen, d.h. die Differenzstufe 62 erhält am oberen, addierenden Eingang und der Addierer 6 am linken Eingang ständig das Signal Null. An der Stelle C kann zunächst die Verbindung noch vorhanden sein.

Das dem Eingang 1 zugeführte quantisierte Vorhersagefehlersignal e', das bei Übertragung von kodierten Vorhersagefehlersignalen bzw. Quantisierstufennummern zunächst durch einfache Zuordnung daraus gebildet wird, was hier nicht dargestellt ist, wird somit über die Verzögerungsanordnung 24, die hier für die Funktion nicht erforderlich ist, dem subtrahierenden Eingang der Differenzstufe 62 zugeführt. Damit tritt am linken Eingang des Addierers 64 das negative quantisierte Vorhersagefehlersignal -e' auf. Unter der Annahme, daß am Ausgang auf der Leitung 3 das negative rekonstruierte Signal -s' auftritt, erzeugt der Zuordner 58, der hier eine Multiplikation nur mit dem Koeffizienten $a_1$ allein durchführt, am Ausgang das

Signal -a₁s', das auch dem rechten Eingang des Addierers 6 und damit auch dem Teilprädiktor 14 zugeführt wird, so daß am unteren Eingang des Addierers 64 das negative zweite Vorhersageteilsignal -s"$_T$ anliegt, das also aus dem rekonstruierten Signal s' unter Berücksichtigung der Koeffizienten a$_K$ bis a$_M$ bestimmt worden ist.

Die im Addierer 64 gebildete Summe wird nun über die Verzögerungsstufe 65 der Kette aus den Elementen 66 bis 69 zugeführt, wo das rekonstruierte Signal -s' mit den übrigen Koeffizienten a₁ bis a$_L$ multipliziert und zur zugeführten Summe zeitrichtig addiert wird. Auf diese Weise entsteht am Ausgang der Verzögerungsstufe 69 tatsächlich die negative Summe aus dem dem Eingang 1 zugeführten quantisierten Vorhersagefehlersignal e' und den vorhergehenden rekonstruierten Signalwerten s', jeweils zeitrichtig mit allen Koeffizienten a₁ bis a$_M$ multipliziert, d.h. das rekonstruierte Signal s', wie in Fig. 11 dargestellt, lediglich mit negativem Vorzeichen. Dieses Vorzeichen kann jedoch über den Quantisierer 4, der ebenfalls üblicherweise als Zuordner ausgeführt ist, umgekehrt werden. Auf diese Weise bleiben bei Verwendung der Anordnung nach Fig. 5 als Demodulator Eingang und Ausgang unverändert, lediglich an den Stellen A und B ist jeweils eine Verbindung unterbrochen, und die Zuordner 56 bis 58 und der Quantisierer 4 sind in ihrem Inhalt entsprechend angepaßt. Im übrigen kann anstelle der Unterbrechungen der Verbindungen an den Stellen A und B die Verbindung an der Stelle C unterbrochen werden, wodurch ebenfalls die Differenzstufe 62 am oberen Eingang und der Addierer 6 am linken Eingang ständig das Signal Null erhält. In entsprechender Weise kann der Demodulator auch gemäß den anderen Anordnungen nach Fig. 2 bzw. Fig. 4 oder 6 oder 8 ausgebildet sein.

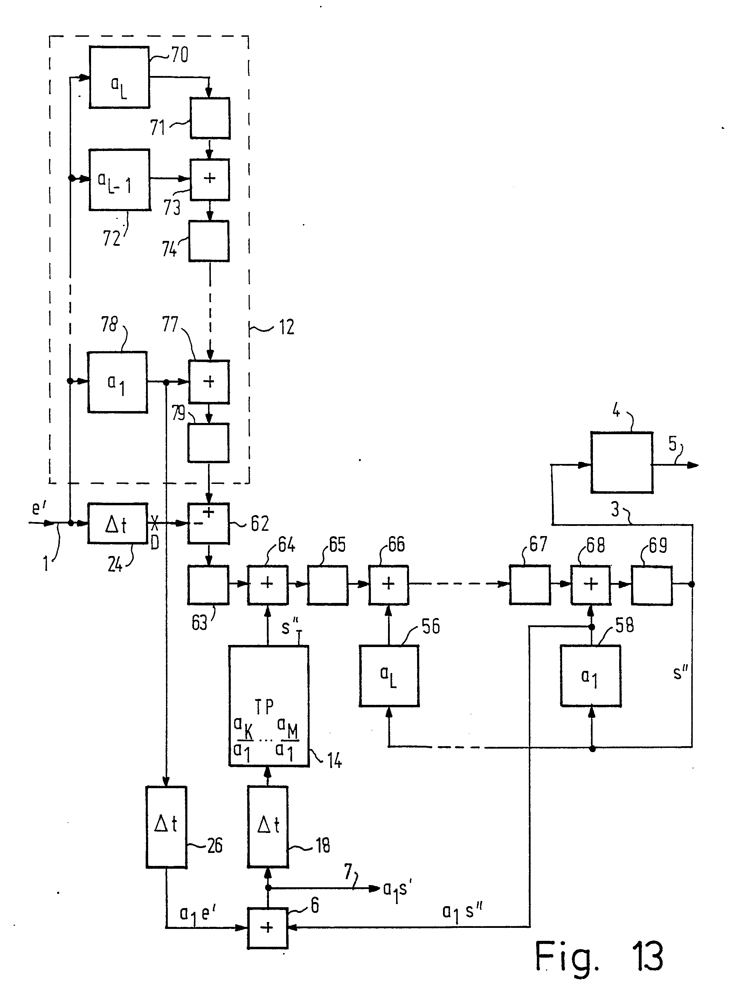

Eine andere Ausbildung des Demodulators, die sich aus der Anordnung nach Fig. 5 ergibt, ist in Fig. 13 dargestellt. Dort wird durch die Unterbrechung an der Stelle D am Ausgang der Verzögerungsstufe 24, wobei diese Unterbrechungsstelle selbstverständlich auch am Eingang dieser Verzögerungsstufe liegen kann, erreicht, daß bei Zuführung des quantisierten Vorhersagefehlersignals e' am Eingang 1 das rekonstruierte Signal s', jedoch mit dem Koeffizienten a₁ als konstantem Faktor, auf der Ausgangsleitung 7 des Addierers 6 auftritt, wie dies im übrigen auch bei der Anordnung nach Fig. 12 der Fall ist. Das rekonstruierte Signal tritt also nicht am Ausgang 3 bzw. 5 wie bei der Verwendung als Modulator auf.

Die Unterbrechung an der Stelle D entspricht einer Aufteilung der bereits früher genannten Gleichung (7) für jeden Vorhersagesignalwert

$$s''(n) = \sum_{m=1}^{M} a_m \, s'(n-m) \tag{7}$$

in zwei Summanden, wie in Gleichung (10) angegeben ist

$$s''(n) = \sum_{m=1}^{L} a_m \, s'(n-m) + \sum_{m=K}^{M} a_m \, s'(n-m) \tag{16}$$

Ferner wird die erste Teilsumme gemäß der früher genannten Gleichung (2) aufgeteilt, während die zweite Teilsumme gemäß der früher genannten Gleichung (15) das zweite Vorhersageteilsignal s"$_T$ darstellt, so daß sich für den Vorhersagesignalwert s"(n) folgende Gleichung ergibt

$$s''(n) = \sum_{m=1}^{L} a_m \, s''(n-m) + \sum_{m=1}^{L} a_m \, e'(n-m) + s''_T(n) \tag{17}$$

Bei der Anordnung nach Fig. 13 tritt das zweite Vorhersageteilsignal wieder am Ausgang des Teilprädiktors 14 auf, während der mittlere Term der Summe in Gleichung (17) im Vorprädiktor 12 und der erste Term schließlich in dem Nachprädiktor mit den Elementen 66 bis 69 in Verbindung mit den Speichern 56 bis 58 gebildet wird.

Der konstante Faktor $a_1$ beim rekonstruierten Signal s′ auf der Ausgangsleitung 7 des Addierers 6 bildet normalerweise keine Schwierigkeiten, insbesondere, wenn dieses Signal zur Ansteuerung einer Bildwiedergabeanordnung verwendet wird.

Auch für die Anordnung nach Fig. 13 gilt das in der Erläuterung der Fig. 12 zum Schluß Gesagte, nämlich der Demodulator kann auch durch entsprechende Änderung bei den Anordnungen nach Fig. 2 bzw. 4 oder 6 oder 8 gebildet werden.

### Ansprüche

1. System zum Übertragen oder Speichern von Eingangssignalen mit einem eingangsseitigen Differenzpulscodemodulator, der die einem Systemeingang zugeführten Eingangssignale in Form einer Folge von mit einem Taktsignal nacheinander auftretenden Signalwerten empfängt und mit jedem Taktsignal einen quantisierten Vorhersagefehlersignalwert an einem Modulatorausgang abgibt, und mit einem ausgangsseitigen Differenzpulscodedemodulator, der an einem Demodulatoreingang die quantisierten Vorhersagefehlersignalwerte in Form einer mit einem Taktsignal auftretenden Folge empfängt und zu jedem Vorhersagefehlersignalwert einen rekonstruierten Signalwert erzeugt und einem Systemausgang zuführt,

dadurch gekennzeichnet, daß der Modulator eine Differenzstufe (62), die an einem ersten Eingang mit jedem Taktsignal einen Eingangssignalwert (s(n)) empfängt, einen Quantisierer (4), der mit jedem Taktsignal einen internen erzeugten Vorhersagefehlersignalwert (e(n)) empfängt und den quantisierten Vorhersagefehlersignalwert (e′(n)) abgibt, einen Vorprädiktor (12), einen Teilprädiktor (14) und einen Nachprädiktor (16; 56, 58, 66 bis 69), die mit der Differenzstufe (62) und dem Quantisierer (4) gekoppelt sind und von denen mit jedem Taktsignal

der Vorprädiktor (12) einen ersten Vorhersageteilsignalwert ($s″_V(n)$) aus der Multiplikation einer ersten Anzahl (L) Eingangssignalwerte (s(n-1),...s(n-L)) direkt mit einer zugehörigen ersten Anzahl (L) Koeffizienten ($a_1,...a_L$) und

der Teilprädiktor (14) einen zweiten Vorhersageteilsignalwert ($s″_T(n)$) aus der Multiplikation einer zweiten Anzahl (M-K+1) rekonstruierter Signalwerte (s′(n-K),...s(n-M)) mit einer zugehörigen zweiten Anzahl (M-K+1) Koeffizienten ($a_K,...a_M$) erzeugt, wobei die zweite Anzahl rekonstruierter Singalwerte zu einer Anzahl früherer Eingangssignalwerte gehört, die mit einer zeitlichen Lücke vor der ersten Anzahl liegen, und im Nachprädiktor (16), der eine in Reihe geschaltete Kette aus einer der ersten Anzahl (L) entsprechenden Anzahl von abwechselnd einem weiteren Addierer (66, 68) und einer Verzögerungsstufe (69) mit einer Verzögerungszeit von je einer Taktzeit enthält,

-der erste (66) der weiteren Addierer (66, 68) an einem Eingang die Differenz aus einem Eingangssignalwert (s(n)) und der Summe der beiden Vorhersageteilsignalwerte ($s″_V(n),s″_T(n)$), von denen mindestens der zweite Vorhersageteilsignalwert ($s″_T(n)$) durch eine erste Verzögerungsanordnung (18) zeitrichtig verschoben ist, erhält und

-alle weiteren Addierer (66, 68) der Kette an ihren nicht mit einer Verzögerungsstufe verbundenen Eingängen das Ausgangssignal jeweils eines vom Vorhersagefehlersignalwert (e(n)) direkt angesteuerten Zuordners (56, 58) erhalten und

-die letzte Verzögerungsstufe (69) der Kette den Vorhersagefehlersignalwert (e(n)) abgibt, und einen ersten Addierer (6) enthält, der mit jedem Taktsignal an einem ersten Eingang den aus dem Vorhersagefehlersignalwert (e(n)) in einer weiteren

Stufe (20, 22, 58) gebildete Quantisierungsfehlersignalwert (q(n)) und an einem zweiten Eingang über eine zweite Verzögerungsanordnung (26) mit einer der ersten Anzahl (L) Taktsignale entsprechenden Verzögerungszeit den Eingangssignalwert (s(n)), der dem Vorhersagefehlersignalwert (e(n)) zeitlich entspricht, empfängt, und jeweils einen rekonstruierten Signalwert (s′(n)) abgibt, und daß der Demodulator wenigstens einen Teilprädiktor (14) mit zugehöriger erster Verzögerungsanordnung (18) und einen Nachprädiktor (56, 58, 66 bis 69) enthält, die entsprechend dem Modulator aufgebaut sind und von denen der Nachprädiktor (56, 58, 66 bis 69) wenigstens die Summe eines Ausgangssignalwerts des Teilprädiktors (14) und eines vom quantisierten Vorhersagefehlersignalwerts (e′(n)) am Demodulatoreingang (1) abgeleiteten Signalwerts und der Teilprädiktor (14) einen vom Ausgang (3) des Nachprädiktors (56, 58, 66 bis 69) abgeleiteten Signalwert empfangen und die rekonstruierten Signalwerte (s′(n)) von den Ausgangssignalwerten des Nachprädiktors ableitbar sind.

2. System nach Anspruch 1,

dadurch gekennzeichnet, daß wenigstens im Modulator für die Bildung der Summe der beiden Vorhersageteilsignalwerte ($s″_V(n)$, $s″_T(n)$) und der Differenz mit dem Eingangssignalwert (s(n)) je ein eigener Addierer (64) bzw. eine eigene Differenzstufe (62) vorgesehen ist, denen jeweils eine Verzögerungsstufe (65, 63) für eine Taktzeit nachgeschaltet ist, die das jeweilige Zwischenergebnis bzw. Endergebnis liefert, und daß die Verzögerung der Signale durch diese Verzögerungsstufen (65, 63) in der Verzögerungszeit der ersten und der zweiten Verzögerungsanordnung (18, 26) berücksichtigt ist.

3. System nach Anspruch 1 oder 2,

dadurch gekennzeichnet, daß mindestens der Vorprädiktor (12) eine weitere Kette aus abwechselnd einem weiteren Addierer (73, 77) und einer Verzögerungsstufe (74, 79) enthält, von denen die weiteren Addierer (73, 77) an ihren anderen, nicht für die Reihenschaltung verwendeten Eingängen die dem Vorprädiktor zugeführten Signalwerte über Multiplizierer (70, 72, 78) empfangen, die die Multiplikation eines Koeffizienten mit einem Signalwert durch dessen im Taktsignalabstand aufeinanderfolgende stellenverschobene Addition durchführen, wobei die Gesamtverzögerung in jedem Multiplizierer (70, 72, 78) gleich ist, und daß die Differenzstufe (62) die Eingangssignalwerte (s) über eine dritte Verzögerungsanordnung (24) erhält, deren Verzögerungszeit der Gesamtverzögerung jedes Multiplizierers (70, 72, 78) entspricht.

4. System nach Anspruch 3,

dadurch gekennzeichnet, daß auch der Teilprädiktor (14) entsprechend dem Vorprädiktor (12) aufgebaut ist und daß die Verzögerungszeit der mit dem Teilprädiktor (14) in Reihe geschalteten ersten Verzögerungsanordnung (18) um die Gesamtverzögerung der Multiplizierer im Teilprädiktor (14) verkürzt gewählt ist.

5. System nach Anspruch 3 oder 4,

dadurch gekennzeichnet, daß der erste der im Vorprädiktor (12) enthaltenen weiteren Addierer (75) am einen Eingang die zweiten Vorhersageteilsignalwerte ($s''_T(n)$) von dem Ausgang des Teilprädiktors (14) empfängt und daß die Verzögerungszeit der ersten Verzögerungsanordnung (18) zusätzlich um die Anzahl Verzögerungsstufen (71, 74, 79) in der weiteren Kette im Vorprädiktor (12) kürzer gewählt ist.

6. System nach einem der Ansprüche 1 bis 5,

dadurch gekennzeichnet, daß der erste Eingang des ersten Addierers (6) den mit einem Koeffizienten ($a_1$) multiplizierten Quantisierungsfehlersignalwert ($a_1q(n)$) aus dem Zuordner (58) des Nachprädiktors (16) und der zweite Eingang des ersten Addierers (6) den mit dem gleichen Koeffizienten ($a_1$) multiplizierten Eingangssignalwert ($a_1s(n)$) aus dem entsprechenden Multiplizierer (78) des Vorprädiktors (12) erhält und daß der Teilprädiktor (14) Multiplikationen mit der zweiten Anzahl Koeffizienten, die durch den in den Signalwerten des ersten Addierers (6) enthaltenen Koeffizienten dividiert sind, ausführt.

7. System nach einem der Ansprüche 1 bis 6 mit adaptiver Prädiktion,

dadurch gekennzeichnet, daß mehrere einzelne Differenzpulscodemodulatoren (98-1, 98-2,...98-I) vorgesehen sind, von denen das Ausgangssignal der ersten Kette über Multiplizierer (94-1, 94-2,...94-I) zur Multiplikation mit einzelnen Gewichtsfaktoren, deren Summe gleich 1 ist, einem Summierer (96) zugeführt sind, dessen Ausgangssignal das adaptive Vorhersagefehlersignal darstellt, das dem gemeinsamen Quantisierer (4) und in jedem einzelnen Differenzpulscodemodulator (98-1, 98-2,...98-I) dem Zuordner (56, 58) zugeführt ist.

8. System nach Anspruch 7,

dadurch gekennzeichnet, daß die Multiplizierer (94-1, 94-2,...94-I) und der Summierer (96) durch einen adaptiv gesteuerten Multiplexer ersetzt sind.

9. System nach einem der Ansprüche 1 bis 8,

dadurch gekennzeichnet, daß die Quantisierungskennlinie des Quantisierers (4) und die Bildung der Produkte im Zuordner (56, 58) umschaltbar ist.

10. Modulator für ein System nach einem der Ansprüche 1 bis 9 mit einem Eingang für eine Folge von Eingangssignalwerten und einen Ausgang für eine Folge von quantisierten Vorhersagefehlersignalwerten,

dadurch gekennzeichnet, daß der Modulator eine Differenzstufe (62), die an einem ersten Eingang mit jedem Taktsignal einen Eingangssignalwert ($s(n)$) empfängt, einen Quantisierer (4), der mit jedem Taktsignal einen internen erzeugten Vorhersagefehlersignalwert ($e(n)$) empfängt und den quantisierten Vorhersagefehlersignalwert ($e'(n)$) abgibt, einen Vorprädiktor (12), einen Teilprädiktor (14) und einen Nachprädiktor (16; 56, 58, 66 bis 69), die mit der Differenzstufe (62) und dem Quantisierer (4) gekoppelt sind und von denen mit jedem Taktsignal

der Vorprädiktor (12) einen ersten Vorhersageteilsignalwert ($s''_V(n)$) aus der Multiplikation einer ersten Anzahl (L) Eingangssignalwerte ($s(n-1),...s(n-L)$) direkt mit einer zugehörigen ersten Anzahl (L) Koeffizienten ($a_1,...a_L$) und

der Teilprädiktor (14) einen zweiten Vorhersageteilsignalwert ($s''_T(n)$) aus der Multiplikation einer zweiten Anzahl ($M-K+1$) rekonstruierter Signalwerte ($s'(n-K),...s(n-M)$) mit einer zugehörigen zweiten Anzahl ($M-K+1$) Koeffizienten ($a_K,...a_M$) erzeugt, wobei die zweite Anzahl rekonstruierter Singalwerte zu einer Anzahl früherer Eingangssignalwerte gehört, die mit einer zeitlichen Lücke vor der ersten Anzahl liegen, und im Nachprädiktor (16), der eine in Reihe geschaltete Kette aus einer der ersten Anzahl (L) entsprechenden

16

Anzahl von abwechselnd einem weiteren Addierer (66, 68) und einer Verzögerungsstufe (69) mit einer Verzögerungszeit von je einer Taktzeit enthält,

-der erste (66) der weiteren Addierer (66, 68) an einem Eingang die Differenz aus einem Eingangssignalwert $(s(n))$ und der Summe der beiden Vorhersageteilsignalwerte $(s''_V(n), s''_T(n))$, von denen mindestens der zweite Vorhersageteilsignalwert $(s''_T(n))$ durch eine erste Verzögerungsanordnung (18) zeitrichtig verschoben ist, erhält und

-alle weiteren Addierer (66, 68) der Kette an ihren nicht mit einer Verzögerungsstufe verbundenen Eingängen das Ausgangssignal jeweils eines vom Vorhersage
fehlersignalwert $(e(n))$ direkt angesteuerten Zuordners (56, 58) erhalten und

-die letzte Verzögerungsstufe (69) der Kette den Vorhersagefehlersignalwert $(e(n))$ abgibt, und einen ersten Addierer (6) enthält, der mit jedem Taktsignal an einem ersten Eingang den aus dem Vorhersagefehlersignalwert $(e(n))$ in einer weiteren
Stufe (20, 22, 58) gebildete Quantisierungsfehlersignalwert $(q(n))$ und an einem zweiten Eingang über eine zweite Verzögerungsanordnung (26) mit einer der ersten Anzahl (L) Taktsignale entsprechenden Verzögerungszeit den Eingangssignalwert $(s(n))$, der dem Vorhersagefehlersignalwert $(e(n))$ zeitlich entspricht, empfängt, und jeweils einen rekonstruierten Signalwert $(s'(n))$ abgibt.

11. Demodulator für ein System nach einem der Ansprüche 1 bis 9 mit einem Eingang für quantisierte Vorhersagefehlersignalwerte und einem Ausgang für rekonstruierte Signalwerte,
dadurch gekennzeichnet, daß wenigstens ein Teilprädiktor (14) mit zugehöriger erster Verzögerungsanordnung (18), ein Nachprädiktor (56, 58, 66 bis 69) und eine Summierstufe (64) vorgesehen sind, von denen Eingänge der Summierstufe (64) mit dem Eingang (1) des Demodulators und mit einem Ausgang des Teilprädiktors (14) und ein Ausgang der Summierstufe (64) mit einem Eingang des Nachprädiktors und ein Ausgang des Nachprädiktors mit einem Eingang des Teilprädiktors (14) und mit dem Ausgang des Demodulators gekoppelt sind.

12. Demodulator für ein System nach einem der Ansprüche 1 bis 9 mit einem Eingang für quantisierte Vorhersagefehlersignalwerte und einem Ausgang für rekonstruierte Signalwerte,
dadurch gekennzeichnet, daß wenigstens ein Vorprädiktor (12,) ein Teilprädiktor (14) mit zugehöriger erster Verzögerungsanordnung (18), ein Nachprädiktor (56, 58, 66 bis 69), eine Summierstufe (64) und ein Addierer (6) vorgesehen sind, von denen ein Eingang des Vorprädiktors (12) mit dem Eingang (1) des Demodulators, Eingänge der Summierstufe (64) mit je einem Ausgang des Vorprädiktors (12) und des Teilprädiktors (14) und ein Ausgang der Summierstufe (64) mit einem Eingang des Nachprädiktors sowie Eingänge des Addierers (6) mit dem Eingang (1) des Demodulators und einem Ausgang des Nachprädiktors und ein Ausgang des Addierers (6) mit einem Eingang des Teilprädiktors (14) und dem Ausgang des Demodulators gekoppelt sind.

Fig. 1

Fig. 2

Fig.3a

Fig.3b

1-VIII-PHD 86-151

Fig. 4

Fig. 5

Fig. 6

$a_{11}$   $a_{01}$   $a_{-1,1}$
•     •     ○     ○     ○     •     •     j-1

•     •     ○     ×     •     •     •     j
$a_{10}$   P

i-1   i   i+1

# Fig. 7

## Fig. 8

Fig. 9

Fig. 10

Fig. 11

Fig. 12

Fig. 13